# EUROPEAN PATENT APPLICATION

(11) **EP 4 219 514 A1**
(43) Date of publication of application: **02.08.2023**
(21) Application number: 21872308.8
(22) Date of filing: 16.09.2021
(51) Int. Cl.: C07F 15/00, C09K 11/06, F21S 2/00, F21S 43/145, F21V 9/30, G09F 9/30, H01L 27/32, H01L 51/50, H05B 33/02, H05B 33/12

(54) **ORGANIC COMPOUND AND ORGANIC LIGHT EMITTING ELEMENT**

(30) Priority: 25.09.2020 JP 2020161442
(71) Applicant: CANON KABUSHIKI KAISHA, Tokyo 146-8501 (JP)
(72) Inventor: NISHIDE Yosuke, Tokyo 146-8501 (JP); IWAWAKI Hironobu, Tokyo 146-8501 (JP); KAMATANI Jun, Tokyo 146-8501 (JP)
(74) Representative: TBK
(86) International application number: PCT/JP2021/034041
(87) International publication number: WO 2022/065178

(57) **Abstract**

Provided is an organometallic complex represented by general formula (1) below.

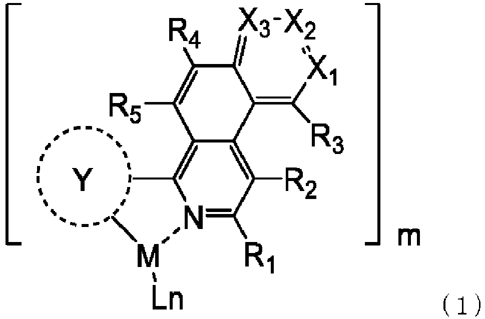

In formula (1), X₁ to X₃ are each independently selected from a carbon atom and a nitrogen atom, and at least one of X₁ to X₃ is a nitrogen atom. The carbon atom has a hydrogen atom or a substituent. Y is an aryl group or a heterocyclic group. L is a bidentate ligand. When a plurality of L's are present, the plurality of L's may be the same or different. M is a metal atom selected from Ir, Pt, Rh, Os, and Zn. m represents an integer of 1 to 3, and n represents an integer of 0 to 2. R₁ to R₅ each represent a hydrogen atom or a substituent.

## Description

### Technical Field

The present invention relates to an organic compound and an organic light-emitting element including the organic compound.

### Background Art

An organic light-emitting element (also referred to as an organic electroluminescent element (organic EL element)) is an electronic element including a pair of electrodes and an organic compound layer disposed between the electrodes. By injecting electrons and holes through the pair of electrodes, excitons of a luminescent organic compound in the organic compound layer are generated. The organic light-emitting element emits light when the excitons return to their ground state.

Recent progress in organic light-emitting elements has been noticeable. For example, low driving voltages, various emission wavelengths, high-speed response, and thinner and lighter light-emitting devices have been enabled.

The sRGB standard and the Adobe RGB standard have been used as color reproduction ranges used for displays, and materials for reproducing them have been required. However, BT-2020 has recently been used as a standard that provides a wider color reproduction range.

Currently, the use of phosphorescence has been proposed as an attempt to improve the light emission efficiency of organic EL elements. Organic EL elements utilizing phosphorescence are expected to have improved light emission efficiency theoretically about four times the light emission efficiency of those utilizing fluorescence. Thus, phosphorescent organometallic complexes have been actively created to date. This is because creation of organometallic complexes having excellent light-emitting properties is important for providing high-performance organic light-emitting elements.

Organometallic complexes created so far include the following compound 1-a disclosed in PTL 1 and the following compound 2-a disclosed in PTL 2.

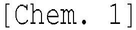

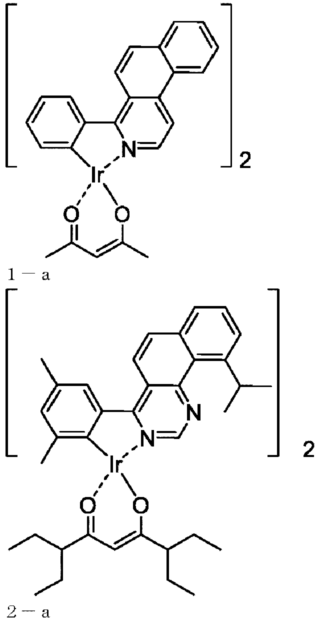

### Citation List

### Patent Literature

PTL 1: Japanese Patent Laid-Open No. 2009-114137
PTL 2: International Publication No. 2019/221487

### Summary of Invention

### Technical Problem

Organic light-emitting elements produced using compounds disclosed in PTLs 1 and 2 can emit light with high light emission efficiency and high color purity, but further improvement is required in order to emit light with chromaticity coordinates of red required for BT-2020.

The present invention has been made to solve the above problem, and an object thereof is to provide an organometallic complex that emits red light with high color purity.

### Solution to Problem

An organometallic complex according to an embodiment of the present invention is represented by general formula (1) below.

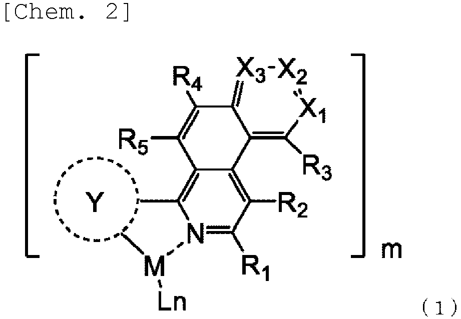

In formula (1), X₁ to X₃ are each independently selected from a carbon atom and a nitrogen atom, and at least one of X₁ to X₃ is a nitrogen atom. The carbon atom has a hydrogen atom or a substituent, and the substituent is selected from a halogen atom, a substituted or unsubstituted alkyl group, a substituted or unsubstituted alkoxy group, a substituted or unsubstituted amino group, a substituted or unsubstituted aryl group, a substituted or unsubstituted heterocyclic group, a substituted or unsubstituted aryloxy group, a silyl group, and a cyano group.

Y is a substituted or unsubstituted aryl group or a substituted or unsubstituted heterocyclic group. The aryl group or the heterocyclic group represented by Y may have a substituent selected from a halogen atom, a substituted or unsubstituted alkyl group, a substituted or unsubstituted alkoxy group, a substituted or unsubstituted amino group, a substituted or unsubstituted aryl group, a substituted or unsubstituted heterocyclic group, a substituted or unsubstituted aryloxy group, a silyl group, and a cyano group.

L is a bidentate ligand. M is a metal atom selected from Ir, Pt, Rh, Os, and Zn. m represents an integer of 1 to 3, and n represents an integer of 0 to 2, provided that m + n = 3.

R₁ to R₅ are each independently selected from a hydrogen atom, a halogen atom, a substituted or unsubstituted alkyl group, a substituted or unsubstituted alkoxy group, a substituted or unsubstituted amino group, a substituted or unsubstituted aryl group, a substituted or unsubstituted heterocyclic group, a substituted or unsubstituted aryloxy group, a silyl group, and a cyano group.

### Advantageous Effects of Invention

According to the present invention, an organometallic complex whose basic skeleton itself can emit red light with high color purity can be provided.

### Brief Description of Drawings

[Fig. 1A] Fig. 1A is a schematic sectional view showing an example of a display device according to an embodiment of the present invention.
[Fig. 1B] Fig. 1B is a schematic sectional view showing another example of a display device according to an embodiment of the present invention.
[Fig. 2] Fig. 2(a) is an example of an image forming apparatus according to an embodiment of the present invention. Fig. 2(b) is an example of an arrangement of light-emitting elements included in a photoreceptor of an image forming apparatus according to an embodiment of the present invention. Fig. 2(c) is another example of an arrangement of light-emitting elements included in a photoreceptor of an image forming apparatus according to an embodiment of the present invention.
[Fig. 3] Fig. 3 is a plan view showing an example of a display device according to an embodiment of the present invention.
[Fig. 4A] Fig. 4A is a schematic view showing an example of a display device according to an embodiment of the present invention.
[Fig. 4B] Fig. 4B is a schematic view showing another example of a display device according to an embodiment of the present invention.
[Fig. 5] Fig. 5 is a schematic view showing an example of an image pickup device according to an embodiment of the present invention.
[Fig. 6] Fig. 6 is a schematic view showing an example of an electronic device according to an embodiment of the present invention.
[Fig. 7] Fig. 7 is a schematic view showing an example of an illumination apparatus according to an embodiment of the present invention.
[Fig. 8] Fig. 8 is a schematic view showing an example of a moving object according to an embodiment of the present invention.
[Fig. 9A] Fig. 9A is a schematic view showing an example of a wearable device according to an embodiment of the present invention.
[Fig. 9B] Fig. 9B is a schematic view of an example of a wearable device according to an embodiment of the present invention, the wearable device including an image pickup device.

### Description of Embodiments

### <Organometallic Complex>

An organometallic complex according to this embodiment will be described. The organometallic complex according to this embodiment is represented by general formula (1) below.

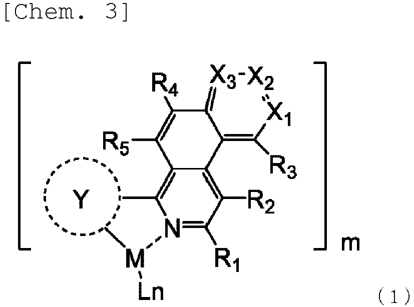

In formula (1), X₁ to X₃ are each independently selected from a carbon atom and a nitrogen atom, and at least one of X₁ to X₃ is a nitrogen atom. The carbon atom has a hydrogen atom or a substituent, and the substituent is selected from a halogen atom, a substituted or unsubstituted alkyl group, a substituted or unsubstituted alkoxy group, a substituted or unsubstituted amino group, a substituted or unsubstituted aryl group, a substituted or unsubstituted heterocyclic group, a substituted or unsubstituted aryloxy group, a silyl group, and a cyano group.

Y is a substituted or unsubstituted aryl group or a substituted or unsubstituted heterocyclic group. The aryl group or the heterocyclic group represented by Y may have a substituent selected from a halogen atom, a substituted or unsubstituted alkyl group, a substituted or unsubstituted alkoxy group, a substituted or unsubstituted amino group, a substituted or unsubstituted aryl group, a substituted or unsubstituted heterocyclic group, a substituted or unsubstituted aryloxy group, a silyl group, and a cyano group.

L is a bidentate ligand. When a plurality of L's are present, the plurality of L's may be the same or different. M is a metal atom selected from Ir, Pt, Rh, Os, and Zn. m represents an integer of 1 to 3, and n represents an integer of 0 to 2. m + n may be 3. All three ligands may be different. When the organometallic complex has different ligands, their triplet excitation energy levels are preferably higher than that of the ligand shown in general formula (1). That is, among lowest triplet excitation energies of the three different ligands, the lowest triplet excitation energy of the ligand shown in general formula (1) is the lowest. This is for reducing the influence on the emission color of the organometallic complex. The ligand shown in general formula (1) refers to a ligand whose coordination number is denoted by m.

R₁ to R₅ are each independently selected from a hydrogen atom, a halogen atom, a substituted or unsubstituted alkyl group, a substituted or unsubstituted alkoxy group, a substituted or unsubstituted amino group, a substituted or unsubstituted aryl group, a substituted or unsubstituted heterocyclic group, a substituted or unsubstituted aryloxy group, a silyl group, and a cyano group.

Examples of substituents that the carbon atoms represented by X₁ to X₃ may have and halogen atoms represented by R₁ to R₅ include fluorine, chlorine, bromine, and iodine, but are not limited thereto.

Examples of substituents that the carbon atoms represented by X₁ to X₃ may have and alkyl groups represented by R₁ to R₅ include alkyl groups having 1 to 10 carbon atoms, preferably 1 to 8 carbon atoms, more preferably 1 to 4 carbon atoms. Specific examples include a methyl group, an ethyl group, a normal propyl group, an isopropyl group, a normal butyl group, a tertiary butyl group, a secondary butyl group, an octyl group, a cyclopentyl group, a cyclohexyl group, a 1-adamantyl group, and a 2-adamantyl group, but are not limited thereto.

Examples of substituents that the carbon atoms represented by X₁ to X₃ may have and alkoxy groups represented by R₁ to R₅ include alkoxy groups having 1 to 10 carbon atoms, preferably 1 to 6 carbon atoms, more preferably 1 to 4 carbon atoms. Specific examples include a methoxy group, an ethoxy group, a propoxy group, 2-ethyl-sixyloxy group, and a benzyloxy group, but are not limited thereto.

Examples of substituents that the carbon atoms represented by X₁ to X₃ may have and amino groups represented by R₁ to R₅ include amino groups substituted with any one of an alkyl group, an aryl group, and an amino group. The alkyl group, the aryl group, and the amino group may have a halogen atom as a substituent. The aryl group and the amino group may have an alkyl group as a substituent. Alkyl substituents on the amino group may be bonded to each other to form a ring. Specific examples include an N-methylamino group, an N-ethylamino group, an N,N-dimethylamino group, an N,N-diethylamino group, an N-methyl-N-ethylamino group, an N-benzylamino group, an N-methyl-N-benzylamino group, an N,N-dibenzylamino group, an anilino group, an N,N-diphenylamino group, an N,N-dinaphthylamino group, an N,N-difluorenylamino group, an N-phenyl-N-tolylamino group, an N,N-ditolylamino group, an N-methyl-N-phenylamino group, an N,N-dianisolylamino group, an N-mesityl-N-phenylamino group, an N,N-dimesitylamino group, an N-phenyl-N-(4-tert-butylphenyl)amino group, an N-phenyl-N-(4-trifluoromethylphenyl)amino group, and an N-piperidyl group, but are not limited thereto.

Examples of substituents that the carbon atoms represented by X₁ to X₃ may have and aryl groups represented by R₁ to R₅ include aryl groups having 6 to 18 carbon atoms. Specific examples include a phenyl group, a naphthyl group, an indenyl group, a biphenyl group, a terphenyl group, a fluorenyl group, a phenanthryl group, and a triphenylenyl group.

Examples of substituents that the carbon atoms represented by X₁ to X₃ may have and heterocyclic groups represented by R₁ to R₅ include heterocyclic groups having 3 to 15 carbon atoms. The heterocyclic groups may have nitrogen, sulfur, or oxygen as a heteroatom. Specific examples include a pyridyl group, a pyrazyl group, a pyrimidyl group, a triazyl group, an imidazolyl group, an oxazolyl group, an oxadiazolyl group, a thiazolyl group, a thiadiazolyl group, a carbazolyl group, an acridinyl group, a phenanthrolyl group, a furanyl group, a thiophenyl group, a dibenzofuranyl group, and a dibenzothiophenyl group, but are not limited thereto.

Examples of substituents that the carbon atoms represented by X₁ to X₃ may have and aryloxy groups represented by R₁ to R₅ include a phenoxy group and a thienyloxy group, but are not limited thereto.

Examples of substituents that the carbon atoms represented by X₁ to X₃ may have and silyl groups represented by R₁ to R₅ include a trimethylsilyl group and a triphenylsilyl group, but are not limited thereto.

The above alkyl groups, alkoxy groups, amino groups, aryl groups, heterocyclic groups, and aryloxy groups may have a halogen atom as a substituent. The halogen atom is, for example, fluorine, chlorine, bromine, or bromine and may be a fluorine atom.

The above amino groups, aryl groups, heterocyclic groups, and aryloxy group may have an alkyl group as a substituent. The alkyl group may have 1 to 10 carbon atoms. More specifically, the alkyl group may be a methyl group, an ethyl group, a normal propyl group, an isopropyl group, a normal butyl group, or a tertiary butyl group.

The above alkyl groups, alkoxy groups, amino groups, aryl groups, heterocyclic groups, and aryloxy groups may have an aryl group as a substituent. The aryl group may have 6 to 12 carbon atoms. More specifically, the aryl group may be a phenyl group, a biphenyl group, or a naphthyl group.

The above alkyl groups, alkoxy groups, amino groups, aryl groups, heterocyclic groups, and aryloxy groups may have a heterocyclic group as a substituent. The heterocyclic group may have 3 to 9 carbon atoms. The heterocyclic group may have nitrogen, sulfur, or oxygen as a heteroatom. More specifically, the heterocyclic group may be a pyridyl group or a pyrrolyl group.

The above alkyl groups, alkoxy groups, amino groups, aryl groups, heterocyclic groups, and aryloxy groups may have an amino group as a substituent. The amino group may have an alkyl group or an aryl group, and alkyl groups on the amino group may be bonded to each other to form a ring. Specifically, the amino group may be a dimethylamino group, a diethylamino group, a dibenzylamino group, a diphenylamino group, or a ditolylamino group.

The above alkyl groups, alkoxy groups, amino groups, aryl groups, heterocyclic groups, and aryloxy groups may have, as a substituent, an aralkyl group such as a benzyl group, an alkoxy group such as a methoxy group, an ethoxy group, or a propoxy group, an aryloxy group such as a phenoxy group, a cyano group, or the like. The substituent is not limited to these examples.

Hereinafter, the specific structure of L in formula (1) will be described. A partial structure ML of the complex including L is a structure including a monovalent bidentate ligand (L).

Here, specific examples of the monovalent bidentate ligand include ligands including acetylacetone, phenylpyridine, picoline acid, oxalate, salen, or the like as a basic skeleton, but are not limited thereto.

The organometallic complex according to an embodiment of the present invention is preferably an organometallic complex represented by formula (1) where M is Ir, and the partial structure MLn is a structure represented by general formula (10) or (11) below.

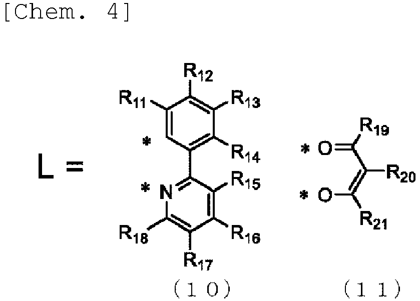

In general formulae (10) and (11), * represents a position of linkage or coordination with iridium, that is, the metal M.

In formulae (10) and (11), R₁₁ to R₂₁ are each independently selected from a hydrogen atom, a halogen atom, a substituted or unsubstituted alkyl group, an alkoxy group, an aralkyl group, a substituted amino group, a substituted or unsubstituted aryl group, and a substituted or unsubstituted heteroaryl group.

In the organic compound according to this embodiment, the presence of a group other than hydrogen atoms, that is, a halogen atom, an alkyl group, an alkoxy group, an amino group, an aryl group, a heterocyclic group, an aryloxy group, a silyl group, or a cyano group, in the basic skeleton can reduce concentration quenching. In addition, this substitution can provide a compound that exhibits improved sublimability when sublimated and that exhibits improved solvent solubility when used for coating.

Next, a method of synthesizing the organometallic complex according to this embodiment will be described. The organometallic complex according to this embodiment is synthesized according to, for example, a reaction scheme shown below.

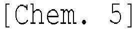

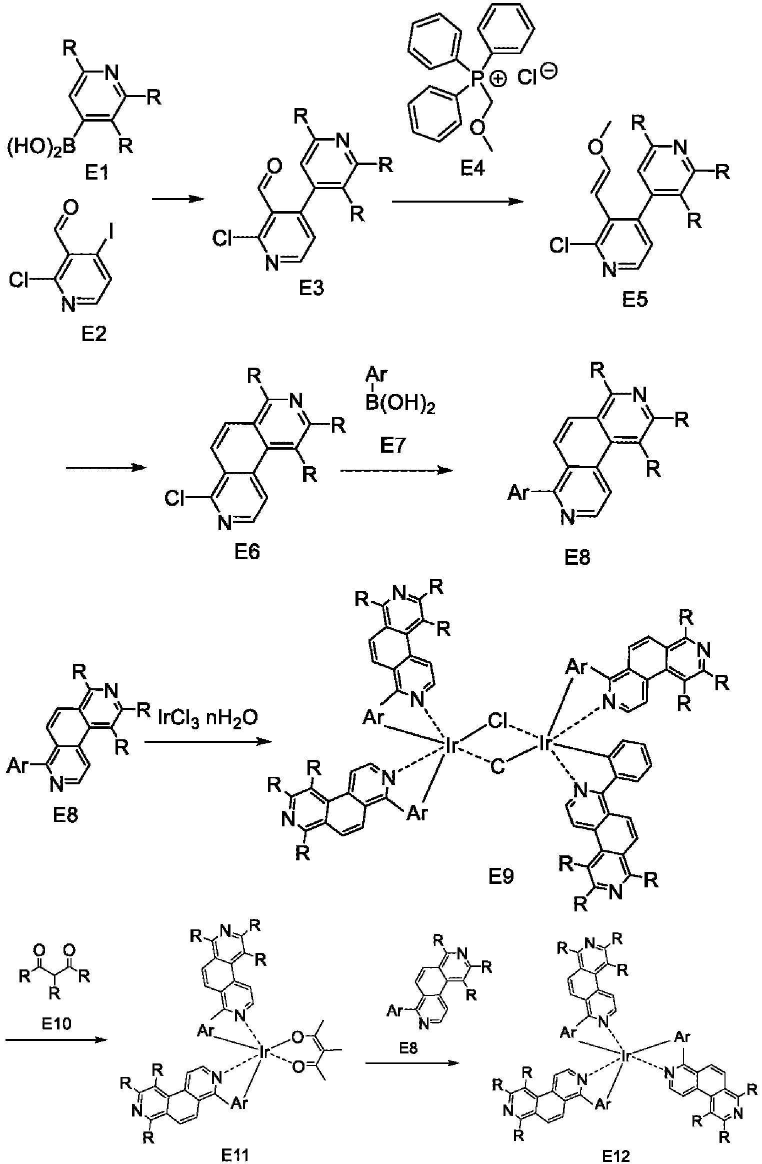

In the above synthesis scheme, the organometallic complex according to this embodiment is synthesized via the following states (a) to (h).
(a) Pyridine derivative (E1)
(b) Aldehyde derivative (E3)
(c) Olefin derivative (E5)
(d) Chlorophenanthroline derivative (E6)
(e) Ligand derivative (E8)
(f) Dichloro dimer derivative (E9)
(g) Acetylacetone derivative (E11)
(h) Tris complex (E12)

In the above synthesis scheme, E1, E7, and E10 can be changed to synthesize various exemplary compounds.

The present invention is not limited to the above synthesis scheme, and various synthesis reagents can be used.

The organometallic complex according to this embodiment has a nitrogen atom at X₁ to X₃ in general formula (1) and thus is a stable compound that highly efficiently emits red light with high color purity. In the following, an organometallic complex having a nitrogen atom at any one of X₁ to X₃ will be mainly described, but two or more of X₁ to X₃ may be nitrogen atoms. When two or more are nitrogen atoms, an organometallic complex having characteristics that combine two or more properties is provided.

Hereinafter, the characteristics of the basic skeleton of the organometallic complex according to the present invention will be described while comparing and contrasting with comparative compounds having structures similar to that of the organometallic complex according to the present invention. Specifically, comparative compound 1-a and comparative compound 2-b, which is the basic form of comparative compound 2-a, shown below are given as the comparative compounds. Here, the basic form refers to a structure in which all substituents on the basic skeleton are hydrogen atoms.

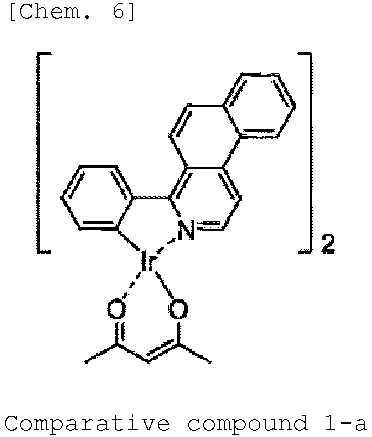

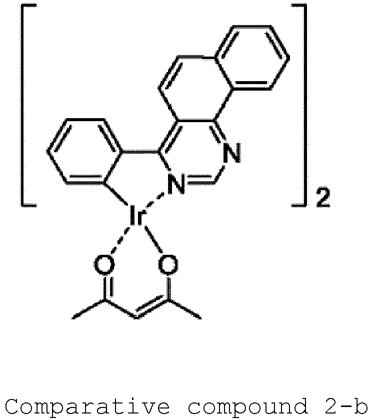

Exemplary compound A1 has a basic skeleton represented by general formula (1), where X₁ and X₃ are each a carbon atom having a hydrogen atom as a substituent, X₂ is a nitrogen atom, Y is an unsubstituted phenyl group, L is acetylacetone, m is 2, and n is 1.

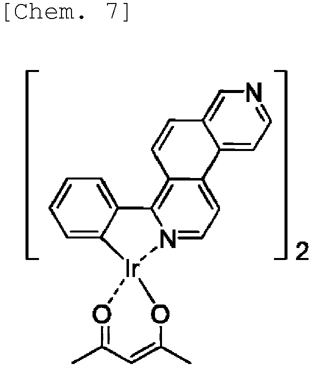

### Exemplary compound A1

[1] Because of having a nitrogen atom at X₁ to X₃, the organometallic complex has a long emission wavelength.

In inventing the organometallic complex represented by formula (1), the present inventors focused on the basic skeleton itself of a ligand of the organometallic complex. Specifically, an attempt was made to obtain a compound that is an organometallic complex having a ligand composed only of a basic skeleton and that has an emission peak in a wavelength region with high color purity. In this embodiment, high color purity means having a maximum emission wavelength in the range of 620 nm or more in a dilute solution. In the CIE coordinates, the X-coordinate is 0.68 or more, and the Y-coordinate is 0.33 or less. Using such a material with high color purity can provide a light-emitting element satisfying the color purity of red light emission in BT-2020.

Here, the inventors compared measured maximum peak wavelengths of comparative compound 1-a and exemplary compound A1 of the present invention. The results are shown in Table 1. The emission wavelengths were measured using an F-4500 manufactured by Hitachi, Ltd. by performing photoluminescence (PL) measurement of a dilute toluene solution at an excitation wavelength of 350 nm at room temperature.

### [Table 1]

**Table 1**

| Compound name | Molecular structure | Emission wavelength/nm (in dilute toluene solution) | Emission quantum yield (ratio relative to comparative compound 1-a taken as 1.0) |
|---|---|---|---|
| Comparative compound 1-a | 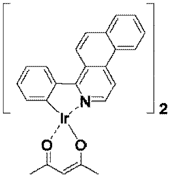 | 600 × | 1.0 ○ |
| Comparative compound 2-b | 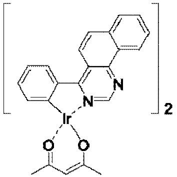 | 621 ○ | 0.8 × |
| Exemplary compound A1 | 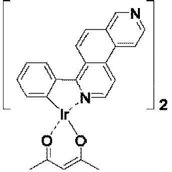 | 627 ○ | 1.1 ○ |

Table 1 shows that the emission color of comparative compound 1-a is red but not in the range of 620 nm or more, that is, the emission color is not in the region of high color purity in this specification. By contrast, exemplary compound A1 has a maximum emission wavelength of 620 nm or more and thus exhibits a long-wavelength red emission color suitable for red in display standards such as BT-2020.

A detailed description will be given below. The present inventors have found that replacing a carbon atom of the benzoisoquinoline skeleton coordinated to the metal atom in comparative compound 1-a with a nitrogen atom results in a longer emission wavelength. That is, the benzoisoquinoline skeleton moiety was replaced with a phenanthroline skeleton by replacing a carbon atom of the benzoisoquinoline skeleton with a nitrogen atom. The phenanthroline skeleton provides an electron-withdrawing effect of the nitrogen atom. Because of the electron-withdrawing effect, the organometallic complex having a phenanthroline skeleton according to the present invention has a lower LUMO (lowest unoccupied molecular orbital) than comparative compound 1-a having a benzoisoquinoline ligand. Accordingly, the organometallic complex has a smaller band gap and hence a longer emission wavelength. The organometallic complex according to the present invention produces the same effect wherever the nitrogen atom is positioned at X₁ to X₃ in general formula (1), and thus the organometallic complex according to the present invention is a compound that has a longer emission wavelength than comparative compound 1-a.

Table 1 shows the ratio of light emission efficiency of each compound relative to the light emission efficiency of comparative compound 1-a taken as 1.0.

From the above, it follows that the organometallic complex according to the present invention can emit red light with high color purity. The chromaticity coordinates of red will be described in detail in EXAMPLES.

[2] Because of having a nitrogen atom at X₁ to X₃, the organometallic complex has high light emission efficiency.

Table 2 shows exemplary compound A1 and comparative compounds 2-b, 2-c, 2-d, and 2-e. On the basis of comparison with these comparative compounds, the properties of the organometallic complex according to the present invention will be described. Table 2 shows the results of molecular orbital calculations of oscillator strength. Conceptual diagrams of conjugate center of gravity and transition based on the molecular orbital calculations are also shown.

### [Table 2]

**Table 2**

| Compound | Exemplary compound A1 | Comparative compound 2-b | Comparative compound 2-c | Comparative compound 2-d | Comparative compound 2-e |
|---|---|---|---|---|---|
| Molecular structure | 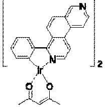 | 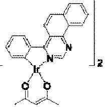 | 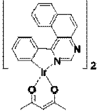 | 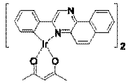 | 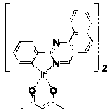 |
| Conceptual diagram of conjugate center of gravity of partial structure and transition | 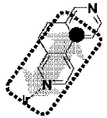 | 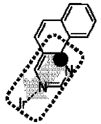 | 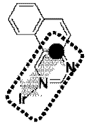 | 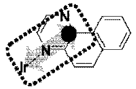 | 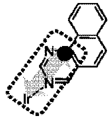 |
| Oscillator strength (calc.) | 1.0 ○ | 0.6 × | 0.6 × | 0.5 × | 0.5 × |

When the electronic transition of an exciton in an organometallic complex is MLCT, an excited electron transits from the metal atom side to the bidentate ligand side. In this case, by designing the molecule such that the center of gravity of the conjugate plane of a ligand is farther from the metal atom, the dipole moment of the complex in an excited state is increased, and the oscillator strength can be improved. That is, the emission quantum yield is increased, and the light emission efficiency can be improved.

In the phenanthroline ligand according to the present invention, the nitrogen atom is disposed at a position far from the metal atom, that is, a position of X₁ to X₃. As illustrated in the conceptual diagrams of conjugate center of gravity and transition shown in Table 2, the conjugate center of gravity of the phenanthroline ligand according to the present invention is farther from the metal atom than those of comparative compounds 2-b to 2-e are. Thus, the dipole moment is increased, and the oscillator strength can be improved, leading to a high emission quantum yield.

By contrast, in each of comparative compounds 2-b to 2-e, the nitrogen atom is disposed at a position relatively close to the metal atom. Accordingly, the conjugate centers of gravity of the ligands of comparative compounds 2-b to 2-e are closer to the metal atom than that of the organometallic complex according to the present invention is. Thus, the dipole moment is decreased, and the oscillator strength is reduced, leading to a low emission quantum yield.

[3] Because of having a nitrogen atom at X₁ to X₃, the organometallic complex has high exciton stability.

As described above, the electronic transition of an exciton in the organometallic complex according to the present invention is from the metal atom side to the phenanthroline side. Since nitrogen has higher electronegativity than carbon, the phenanthroline skeleton, which is derived by replacing a carbon atom of a benzoisoquinoline skeleton with a nitrogen atom, is more strongly polarized than the benzoisoquinoline skeleton and thus has a localized n-electron cloud. Such electron localization makes it difficult for an exciton to stably exist. That is, the localized n-electron cloud due to the nitrogen atom is preferably located away so as to avoid reaction with an exciton. More specifically, the arrow indicating transition shown in Table 2 and the nitrogen atom are preferably separated from each other. When the arrow indicating transition and the nitrogen atom overlap with each other as in comparative compound 2-b, the ratio of excitation energy used for intermolecular reaction, etc. not for light emission in an excited state increases. That is, the light emission efficiency decreases, and thus a larger amount of current is required to achieve the same luminance, resulting in a light-emitting element with a reduced drive endurance time.

Table 1 and Table 2 show the results of element durability of comparative compound 2-b relative to the element durability of exemplary compound A1 shown in EXAMPLES taken as 1.0. Exemplary compound A1 according to the present invention, in which the nitrogen atom is introduced outside a transition dipole moment, is not influenced or not readily influenced by the nitrogen atom in transition. By contrast, comparative compounds 2-b to 2-e, in each of which the nitrogen atom is introduced inside a transition dipole moment, are influenced or readily influenced by the nitrogen atom in transition. Thus, due to less influence by the transition dipole moment, exemplary compound A1 according to the present invention is more stable in an excited state than comparative compounds 2-b to 2-e.

From the above, it follows that the organometallic complex of the present invention has high stability in an excited state. Thus, when the organometallic complex is used as a light-emitting material for an organic light-emitting element, high element driving durability can be provided.

Calculated values of oscillator strength of the molecular structures shown in Table 2 were determined using the following molecular orbital calculations.

As a method of the molecular orbital calculations, the density functional theory (DFT), which is now widely used, was used. The B3LYP functional and the 6-31G* basis function were used. The same results can be obtained if the 6-31G(d) basis function is used. The molecular orbital calculations were performed by Gaussian09 (Gaussian 09, Revision C.01, M. J. Frisch, G. W. Trucks, H. B. Schlegel, G. E. Scuseria, M. A. Robb, J. R. Cheeseman, G. Scalmani, V. Barone, B. Mennucci, G. A. Petersson, H. Nakatsuji, M. Caricato, X. Li, H. P. Hratchian, A. F. Izmaylov, J. Bloino, G. Zheng, J. L. Sonnenberg, M. Hada, M. Ehara, K. Toyota, R. Fukuda, J. Hasegawa, M. Ishida, T. Nakajima, Y. Honda, O. Kitao, H. Nakai, T. Vreven, J. A. Montgomery, Jr., J. E. Peralta, F. Ogliaro, M. Bearpark, J. J. Heyd, E. Brothers, K. N. Kudin, V. N. Staroverov, T. Keith, R. Kobayashi, J. Normand, K. Raghavachari, A. Rendell, J. C. Burant, S. S. Iyengar, J. Tomasi, M. Cossi, N. Rega, J. M. Millam, M. Klene, J. E. Knox, J. B. Cross, V. Bakken, C. Adamo, J. Jaramillo, R. Gomperts, R. E. Stratmann, O. Yazyev, A. J. Austin, R. Cammi, C. Pomelli, J. W. Ochterski, R. L. Martin, K. Morokuma, V. G. Zakrzewski, G. A. Voth, P. Salvador, J. J. Dannenberg, S. Dapprich, A. D. Daniels, O. Farkas, J. B. Foresman, J. V. Ortiz, J. Cioslowski, and D. J. Fox, Gaussian, Inc., Wallingford CT, 2010), which is now widely used.

### [Features of organometallic complex having nitrogen atom at X₂ among X₁ to X₃]

Among the organometallic complexes according to the present invention, an organometallic complex having a nitrogen atom at X₂ in general formula (1), that is, an organometallic complex represented by general formula (2), is a compound that emits light with a longer wavelength, has higher efficiency, and also has higher stability in an excited state.

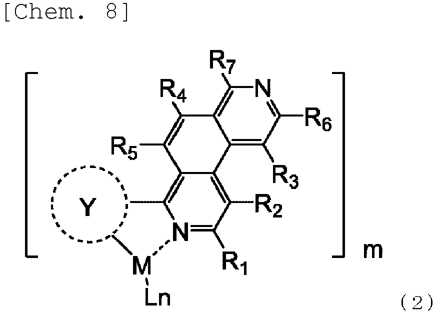

A description will be given of the feature of emitting light with a longer wavelength among the organometallic complexes according to the present invention. In general formula (2), R₁ to R₇ may be selected from the group from which R₁ to R₅ are selected.

In a ring structure having a nitrogen atom, the electron-withdrawing effect of the nitrogen atom is great particularly at ortho and para positions. This can also be seen from the following resonance structural formula. That is, the electron density is lower at ortho and para positions than at other positions. This reduces the electron density of the nitrogen atom coordinated to the metal atom, thus lowering the LUMO of the organometallic complex. This results in a narrower band gap and a longer emission wavelength. Therefore, the organometallic complex having a nitrogen atom at X₂ has a long emission wavelength.

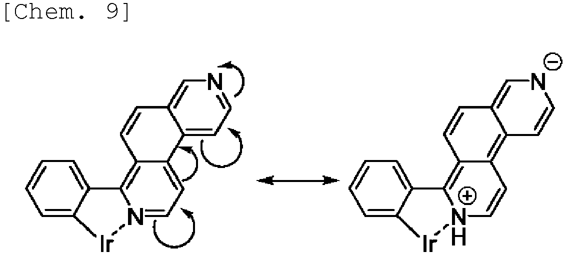

As shown in Table 2, among the organometallic complexes according to the present invention, the organometallic complex having a nitrogen atom at X₂ has a high oscillator strength and a high quantum yield because the center of gravity of the conjugate plane of the ligand is located farther away. Compounds having high quantum yields has high light emission efficiency. Therefore, the organometallic complex having a nitrogen atom at X₂ among the organometallic complexes according to the present invention has high light emission efficiency.

Among the organometallic complexes according to the present invention, the organometallic complex having a nitrogen atom at X₂ also has higher stability in an excited state. This is because the organometallic complex having a nitrogen atom at X₂ can have a quinoid structure when written as a resonance structural formula as shown above. This stabilizes the π-conjugated system, thus providing high stability even in an excited state. As a result, the organometallic complex provides a longer element operating life when used in an organic light-emitting element.

Therefore, the organometallic complex having a nitrogen atom at X₂ is an organometallic complex having high color purity, high efficiency, and a long life.

### [Features of organometallic complex having nitrogen atom at X₁ or X₃ among X₁ to X₃]

Among the organometallic complexes according to the present invention, an organometallic complex having a nitrogen atom at X₁ or X₃ in general formula (1), that is, an organometallic complex represented by general formula (3) or (4), is a compound that can reduce intermolecular interactions.

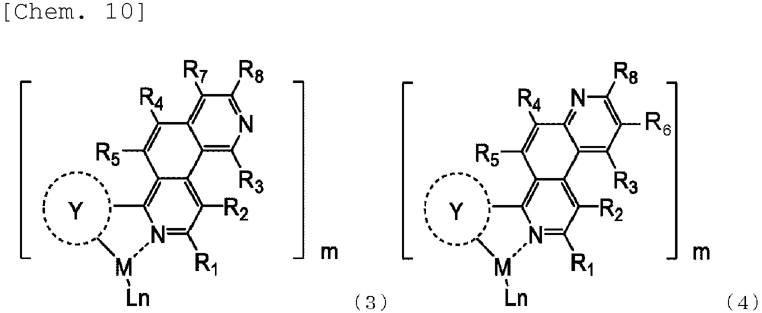

In general formula (3), R₁ to R₅, R₇, and R₈ may be selected from the group from which R₁ to R₅ are selected.

In general formula (4), R₁ to R₆ and R₈ may be selected from the group from which R₁ to R₅ are selected.

Among the organometallic complexes according to the present invention, the organometallic complexes represented by general formulae (3) and (4) are each a compound in which the positional relationship between two nitrogen atoms in the phenanthroline skeleton which is a ligand is asymmetric. This reduces interactions between molecules. The reduction of interactions between molecules increases sublimability.

The improvement in sublimability enables an increase in purity of a material by sublimation purification and the production of an organic light-emitting element by vapor deposition. This can reduce impurities contained in the organic light-emitting element, thus reducing the occurrence of a decrease in light emission efficiency due to impurities and a decrease in driving durability. The reduction in concentration quenching is preferred from the viewpoint of improving the light emission efficiency of the organic light-emitting element.

Y in general formula (1) represents a ring structure. The ring structure may be an aryl group, a heterocyclic group, or an alicyclic structure. More specifically, the ring structure may be a benzene ring, a naphthyl ring, a fluorene ring, a phenanthrene ring, a pyridine ring, a quinoline ring, a triazine ring, a dibenzofuran ring, a dibenzothiophene ring, a cyclohexane ring, or the like. A benzene ring having substituents at 3- and 5-positions thereof is preferred. The 3- and 5-positions are based on the assumption that the position bonded to the phenanthroline skeleton is the 1-position. The substituents are preferably alkyl groups, more preferably methyl groups. That is, 3,5-dimethylbenzene is preferred.

Specific examples of the organometallic complexes according to the present invention are shown below. However, the present invention is not limited to these examples.

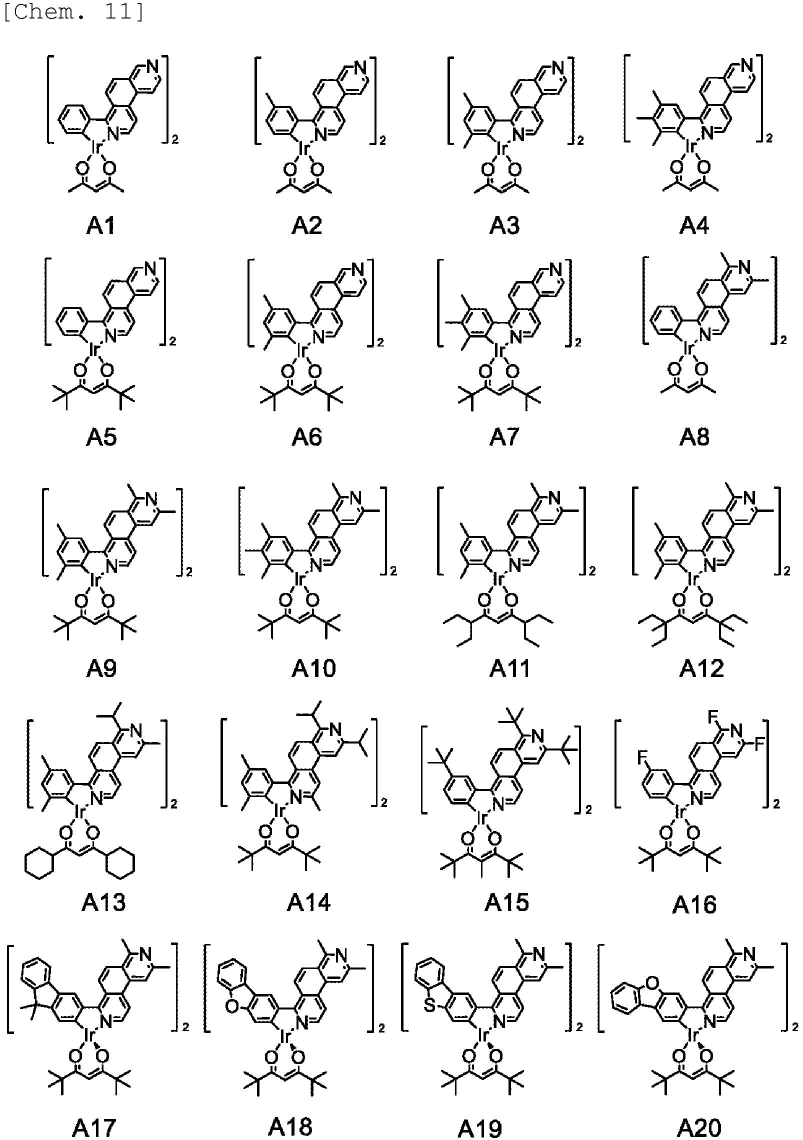

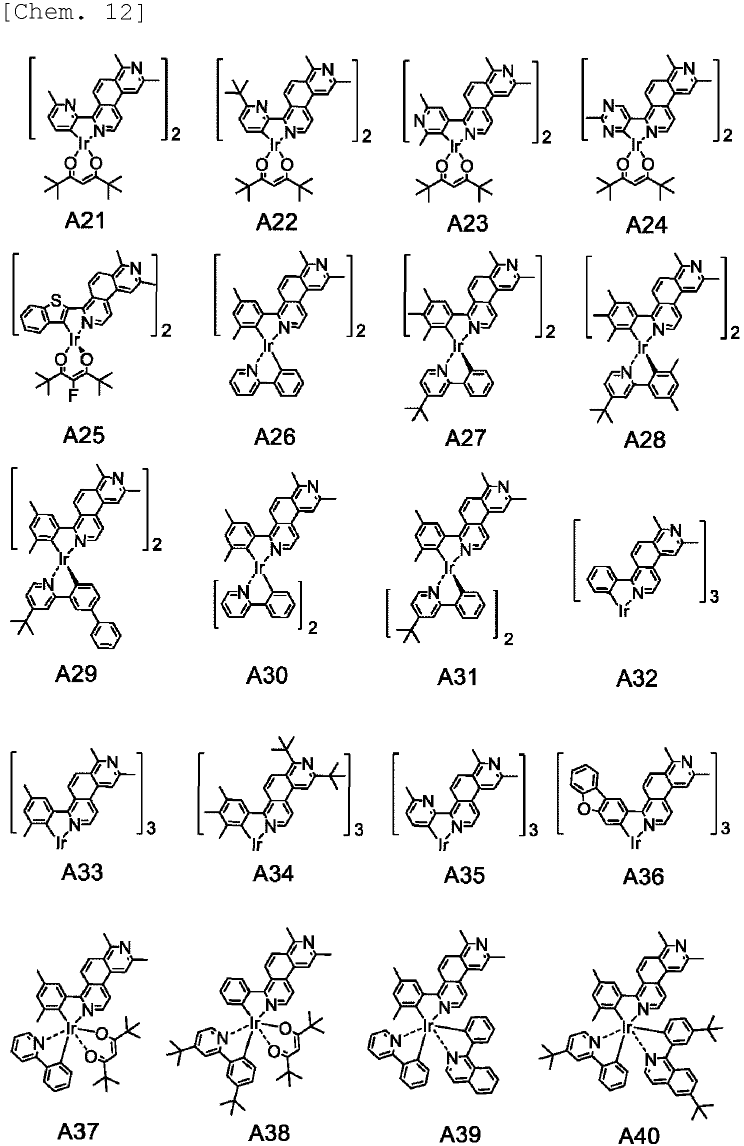

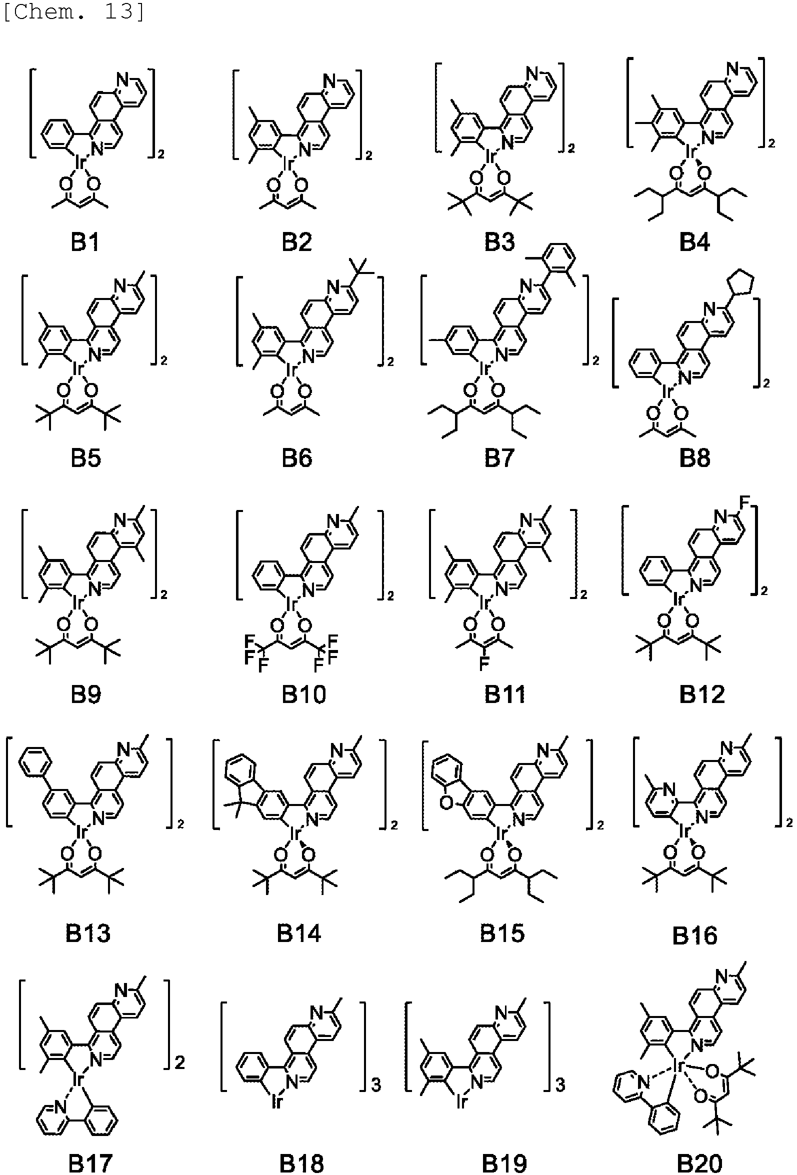

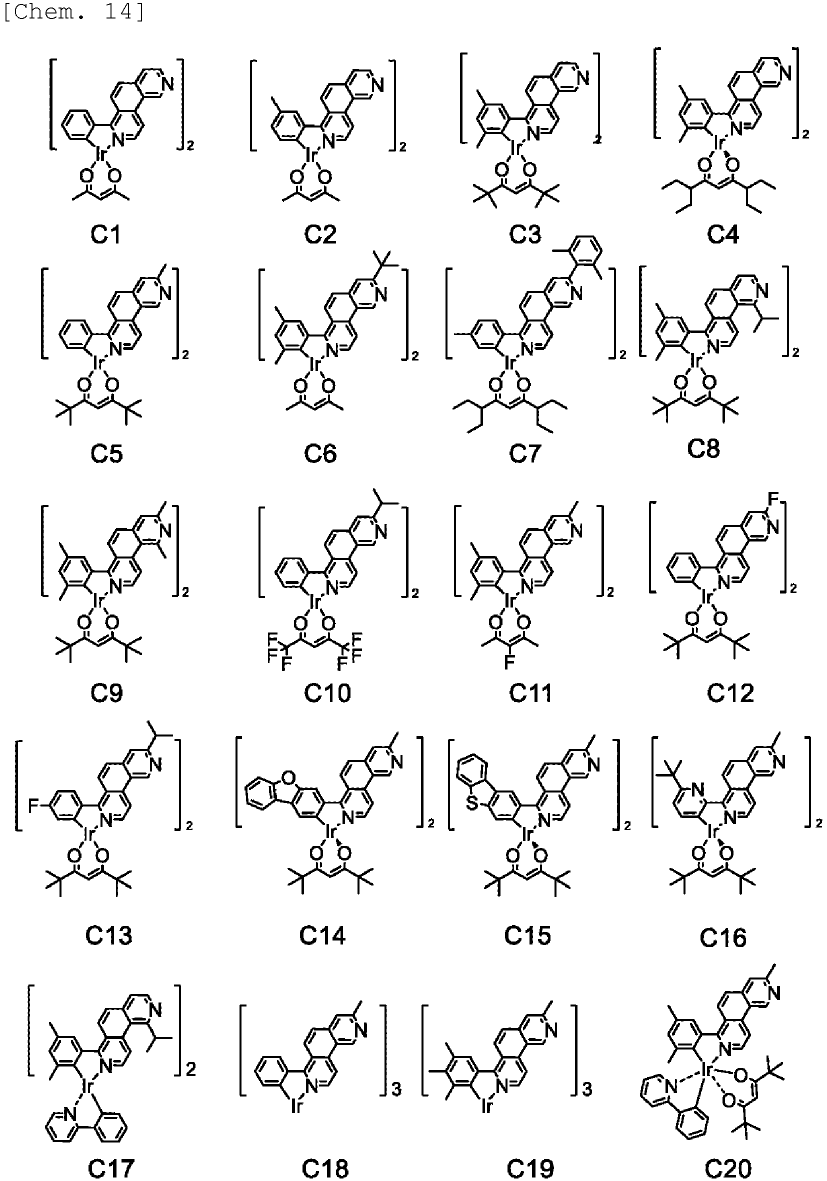

Among the above exemplary compounds, compounds of group A are organometallic complexes represented by general formula (2) and having a nitrogen atom at X₂. Among the organometallic complexes according to the present invention, the compounds of group A are compounds that emit light with longer wavelengths, have higher efficiency, and also have higher stability in excited states.

In group A, A8 to A40 are compounds having a substituent at the ortho position of a nitrogen atom not coordinated to the metal. As described above, the introduction of a nitrogen atom polarizes π-electrons in a ligand, resulting in high electron density on the introduced nitrogen atom. Thus, intramolecular packing is likely to occur. By introducing a substituent at the ortho position of the nitrogen atom not coordinated to the metal, intermolecular packing can be reduced, and sublimability is improved. In addition, in the synthesis of an organometallic complex, if a plurality of coordinatable nitrogen atoms are present when a ligand is coordinated to a metal atom, coordination to a desired position may be prevented. Therefore, by introducing a substituent at the ortho position of a nitrogen atom not coordinated to the metal, coordination to the metal atom can be reduced to facilitate coordination to the desired position. From the above, it follows that among group A, A8 to A40 are more preferred from the viewpoint of reducing intermolecular packing and facilitating metal coordination at a desired position.

The substituent at the ortho position of the nitrogen atom is selected from a halogen atom, a substituted or unsubstituted alkyl group, an alkoxy group, an aralkyl group, a substituted amino group, a substituted or unsubstituted aryl group, and a substituted or unsubstituted heteroaryl group. The substituent at the ortho position of the nitrogen atom may be a halogen atom or an alkyl group. The halogen atom may be a fluorine atom, and the alkyl group may be an alkyl group having 1 to 4 carbon atoms.

In group A, A1 to A25, A37, and A38 are organometallic complexes having a ligand represented by general formula (11) as an ancillary ligand. Among the organometallic complexes according to the present invention, these organometallic complexes are preferred because they have small molecular weights and can sublimate at lower temperatures.

In group A, A26 to A31 are organometallic complexes having a ligand represented by general formula (10) as an ancillary ligand. Among the organometallic complexes according to the present invention, these organometallic complexes are preferred because they have relatively small molecular weights and have high thermal stability.

In group A, A35 and A36 are compounds composed only of the phenanthroline ligand according to the present invention. Among the organometallic complexes according to the present invention, these compounds are preferred because they have higher thermal stability.

Among the above exemplary compounds, compounds of group B and group C are organometallic complexes represented by general formula (4) or (3) and having a nitrogen atom at X₁ or X₃. Among the organometallic complexes according to the present invention, the compounds of group B and group C are compounds that can suppress intermolecular interactions and have high sublimability.

In group B and group C, B5 to B20 and C5 to C20 are compounds having a substituent at the ortho position of a nitrogen atom not coordinated to the metal. As described above, these compounds are more preferred from the viewpoint of reducing intermolecular packing and facilitating metal coordination at a desired position.

The substituent at the ortho position of the nitrogen atom is selected from a halogen atom, a substituted or unsubstituted alkyl group, an alkoxy group, an aralkyl group, a substituted amino group, a substituted or unsubstituted aryl group, and a substituted or unsubstituted heteroaryl group. The substituent at the ortho position of the nitrogen atom may be a halogen atom or an alkyl group. The halogen atom may be a fluorine atom, and the alkyl group may be an alkyl group having 1 to 4 carbon atoms.

In group B and group C, B1 to B16, B20, C1 to C16, and C20 are organometallic complexes having a ligand represented by general formula (11) as an ancillary ligand. Among the organometallic complexes according to the present invention, these compounds are preferred because they have small molecular weights and can sublimate at lower temperatures.

In group B and group C, B17 and C17 are organometallic complexes having a ligand represented by general formula (10) as an ancillary ligand. Among the organometallic complexes according to the present invention, these organometallic complexes are preferred because they have relatively small molecular weights and have high thermal stability.

In group B and group C, B18, B19, C18, and C19 are organometallic complexes composed only of the phenanthroline ligand according to the present invention. Among the organometallic complexes according to the present invention, these organometallic complexes are preferred because they have higher thermal stability.

The organometallic complex according to the present invention is a compound that exhibits light emission suitable for red light emission. Thus, using the organometallic complex according to the present invention as a constituent material for an organic light-emitting element can provide an organic light-emitting element having good light-emitting properties and high durability.

### <<Organic Light-Emitting Element>>

Next, an organic light-emitting element according to this embodiment will be described. The organic light-emitting element according to this embodiment at least includes a first electrode, a second electrode, and an organic compound layer disposed between the electrodes. One of the first electrode and the second electrode is an anode, and the other is a cathode. In the organic light-emitting element according to this embodiment, the organic compound layer may be a single layer or a laminate of a plurality of layers as long as the organic compound layer includes a light-emitting layer. When the organic compound layer is a laminate of a plurality of layers, the organic compound layer may include, in addition to the light-emitting layer, a hole injection layer, a hole transport layer, an electron blocking layer, a hole/exciton blocking layer, an electron transport layer, an electron injection layer, and the like. The light-emitting layer may be a single layer or a laminate of a plurality of layers.

In the organic light-emitting element according to this embodiment, at least one layer of the organic compound layer contains the organometallic complex according to this embodiment. Specifically, the organic compound according to this embodiment is contained in any of the light-emitting layer, the hole injection layer, the hole transport layer, the electron blocking layer, the hole/exciton blocking layer, the electron transport layer, the electron injection layer, and the like described above. The organic compound according to this embodiment is preferably contained in the light-emitting layer.

In the organic light-emitting element according to this embodiment, when the organic compound according to this embodiment is contained in the light-emitting layer, the light-emitting layer may be a layer formed only of the organic compound according to this embodiment or a layer formed of the organometallic complex according to this embodiment and other compounds. When the light-emitting layer is a layer formed of the organometallic complex according to this embodiment and other compounds, the organic compound according to this embodiment may be used as a host or a guest of the light-emitting layer. The organic compound may also be used as an assist material that can be contained in the light-emitting layer. Here, the host refers to a compound accounting for the largest mass proportion among the compounds constituting the light-emitting layer. The guest refers to a compound that accounts for a smaller mass proportion than the host among the compounds constituting the light-emitting layer and that is responsible for main light emission. The assist material refers to a compound that accounts for a smaller mass proportion than the host among the compounds constituting the light-emitting layer and that assists the light emission of the guest. The assist material is also referred to as a second host. The host material can also be referred to as a first compound, and the assist material as a second compound.

When the organic compound according to this embodiment is used as a guest of the light-emitting layer, the concentration of the guest is preferably 0.01 mass% or more and 20 mass% or less, more preferably 0.1 mass% or more and 10 mass% or less, relative to the total mass of the light-emitting layer.

The present inventors have conducted various studies and found that when the organic compound according to this embodiment is used as a host or a guest of a light-emitting layer, particularly, as a guest of a light-emitting layer, an element that outputs light with high efficiency and high luminance and has very high durability can be provided. This light-emitting layer may have a single-layer structure or a multilayer structure. The light-emitting layer may contain a light-emitting material having another emission color so as to emit light having a color mixed with red, which is the emission color of this embodiment. The multilayer structure refers to a state in which the light-emitting layer and another light-emitting layer are stacked on top of each other. In this case, the emission color of the organic light-emitting element is not limited to red. More specifically, the emission color may be white or an intermediate color. In the case of white, the other light-emitting layer emits light of a color other than red, that is, blue or green. The light-emitting layer is formed by vapor deposition or coating. Details thereof will be described in EXAMPLES given later.

The organometallic complex according to this embodiment can be used as a constituent material of an organic compound layer other than the light-emitting layer constituting the organic light-emitting element according to this embodiment. Specifically, the organometallic complex may be used as a constituent material of, for example, the electron transport layer, the electron injection layer, the hole transport layer, the hole injection layer, or the hole blocking layer. In this case, the emission color of the organic light-emitting element is not limited to red. More specifically, the emission color may be white or an intermediate color.

In addition to the organic compound according to this embodiment, known low-molecular-weight and high-molecular-weight hole injection compounds or hole transport compounds, compounds serving as hosts, luminescent compounds, electron injection compounds or electron transport compounds, and the like may optionally be used in combination. Examples of these compounds will be described below.

As hole injection and transport materials, materials that facilitate injection of holes from the anode and that have so high hole mobility that enables injected holes to be transported to the light-emitting layer are preferred. To reduce deterioration of film quality, such as crystallization, in the organic light-emitting element, materials having high glass-transition temperatures are preferred. Examples of low-molecular-weight and high-molecular-weight materials having hole injection and transport properties include triarylamine derivatives, arylcarbazole derivatives, phenylenediamine derivatives, stilbene derivatives, phthalocyanine derivatives, porphyrin derivatives, poly(vinylcarbazole), poly(thiophene), and other conductive polymers. These hole injection and transport materials are also suitable for use in the electron blocking layer. Non-limiting specific examples of compounds usable as hole injection and transport materials are shown below.

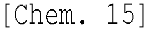

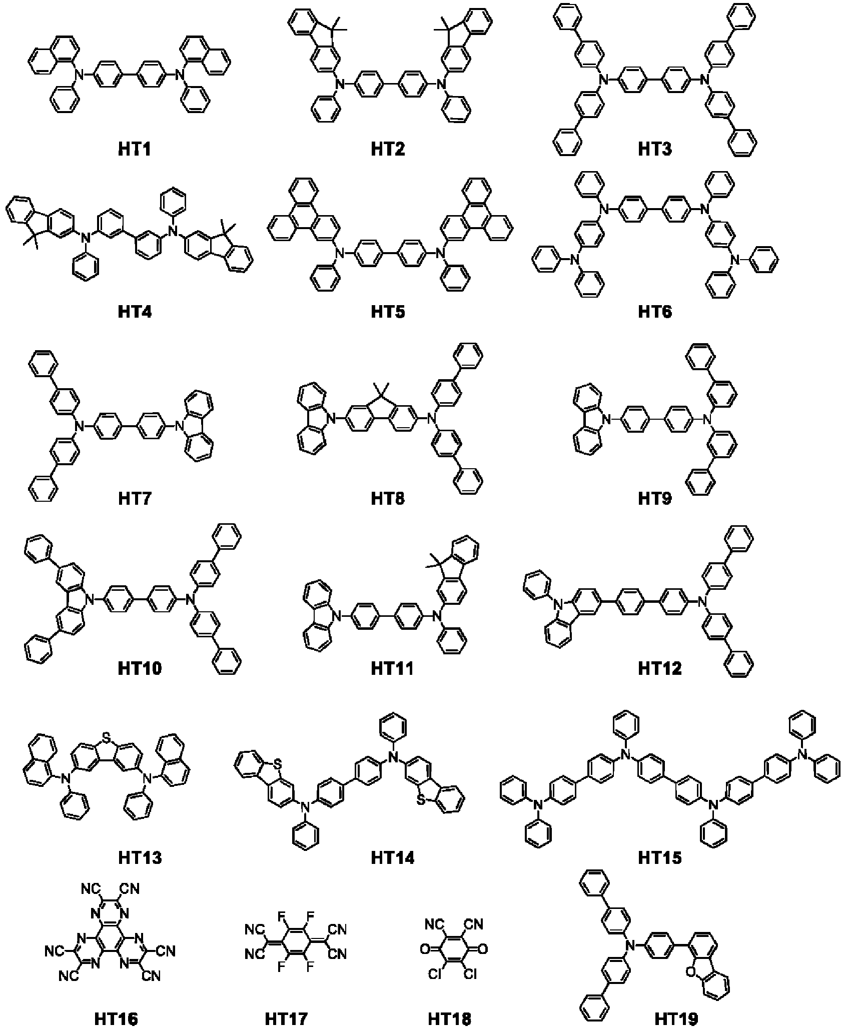

Examples of light-emitting materials mainly involved in the light-emitting function include, in addition to the organometallic complex represented by general formula (1), fused-ring compounds (e.g., fluorene derivatives, naphthalene derivatives, pyrene derivatives, perylene derivatives, tetracene derivatives, anthracene derivatives, and rubrene), quinacridone derivatives, coumarin derivatives, stilbene derivatives, organic aluminum complexes such as tris(8-quinolinolato)aluminum, iridium complexes, platinum complexes, rhenium complexes, copper complexes, europium complexes, ruthenium complexes, and polymer derivatives such as poly(phenylenevinylene) derivatives, poly(fluorene) derivatives, and poly(phenylene) derivatives.

Non-limiting specific examples of compounds usable as light-emitting materials are shown below.

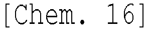

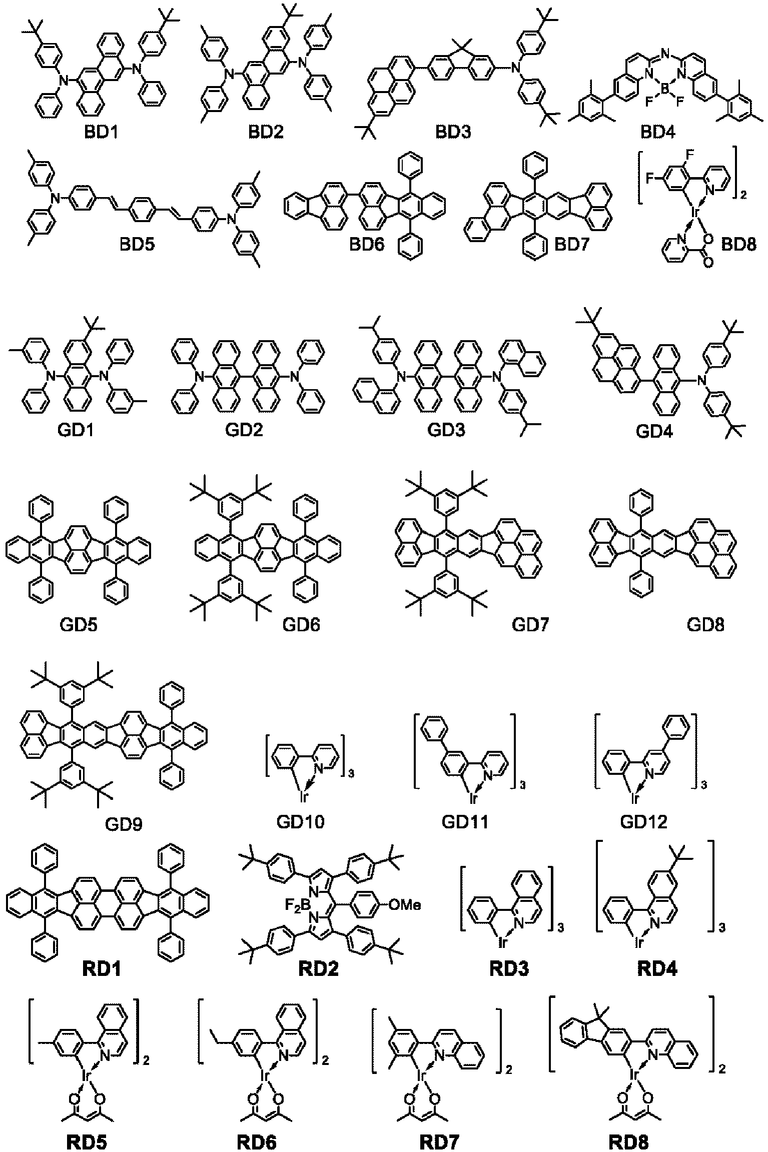

Examples of light-emitting-layer hosts and light emission assist materials contained in the light-emitting layer include aromatic hydrocarbon compounds and derivatives thereof, carbazole derivatives, dibenzofuran derivatives, dibenzothiophene derivatives, organic aluminum complexes such as tris(8-quinolinolato)aluminum, and organic beryllium complexes.

Non-limiting specific examples of compounds usable as light-emitting-layer hosts or light emission assist materials contained in the light-emitting layer are shown below.

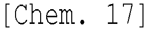

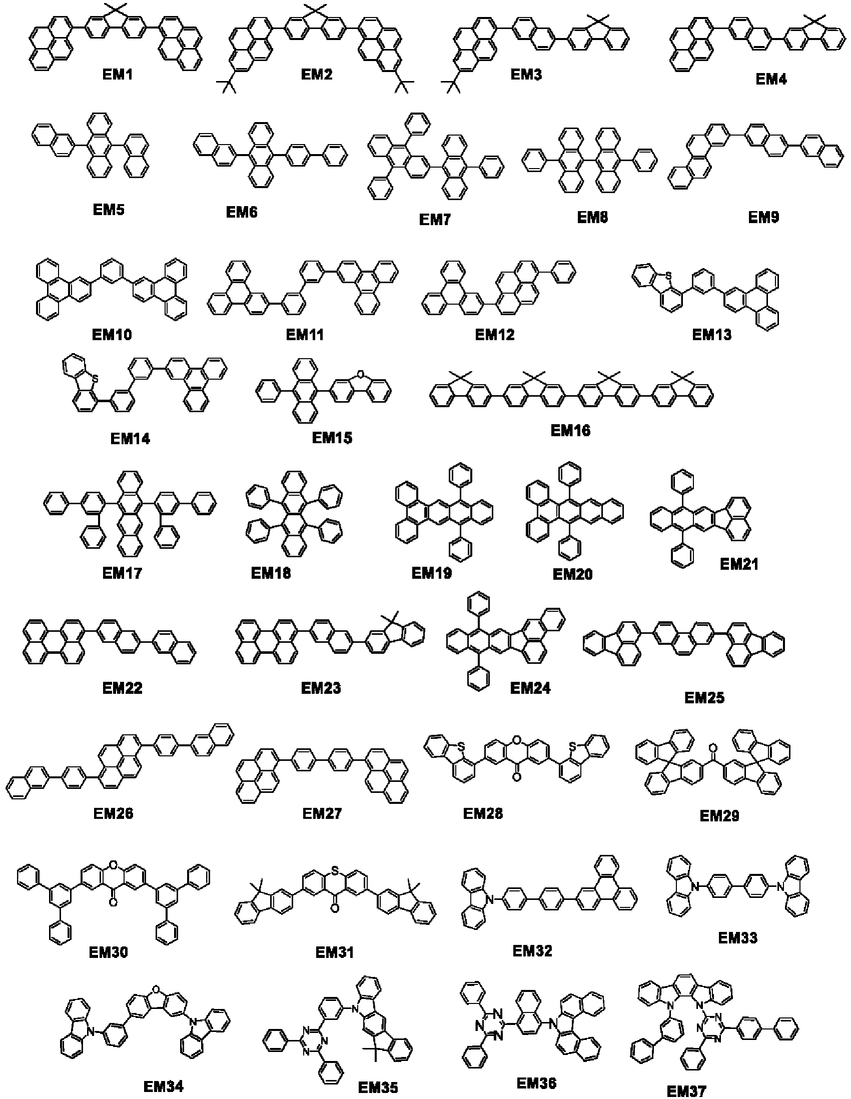

Any electron transport material capable of transporting electrons injected from the cathode to the light-emitting layer can be freely selected in consideration of, for example, the balance with the hole mobility of a hole transport material. Examples of materials capable of transporting electrons include oxadiazole derivatives, oxazole derivatives, pyrazine derivatives, triazole derivatives, triazine derivatives, quinoline derivatives, quinoxaline derivatives, phenanthroline derivatives, organic aluminum complexes, and fused-ring compounds (e.g., fluorene derivatives, naphthalene derivatives, chrysene derivatives, and anthracene derivatives). These electron transport materials are also suitable for use for the hole blocking layer. Non-limiting specific examples of compounds usable as electron transport materials are shown below.

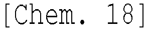

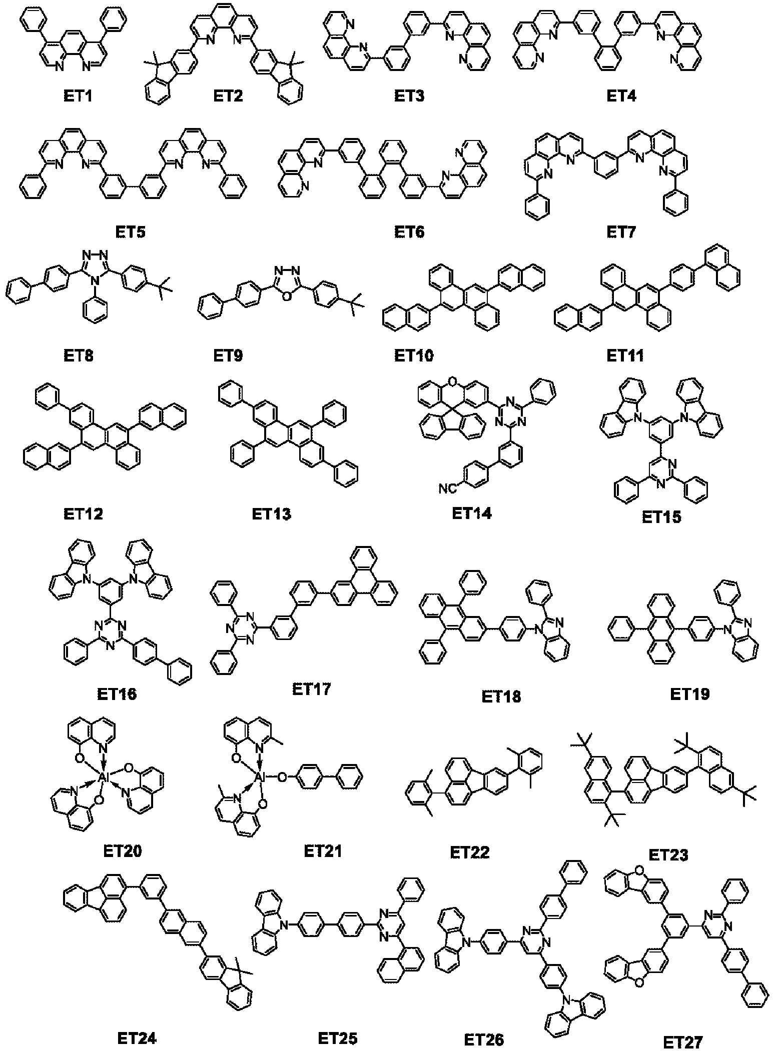

Hereinafter, constituent members other than the organic compound layer that constitute the organic light-emitting element according to this embodiment will be described. The organic light-emitting element may be provided by forming the first electrode, the organic compound layer, and the second electrode on a substrate. A protective layer, a color filter, and the like may be disposed on the second electrode. When the color filter is disposed, a planarization layer may be disposed between the protective layer and the color filter. The planarization layer may be composed of an acrylic resin or the like.

The substrate may be made of quartz, glass, silicon, resin, metal, or the like. A switching element such as a transistor and a wire may be disposed on the substrate, and an insulating layer may be disposed thereon. The insulating layer may be made of any material as long as contact holes can be formed in order to provide electrical connection between the anode and the wire and insulation from unconnected wires can be provided. For example, resins such as polyimide, silicon oxide, and silicon nitride can be used.

The constituent material for the anode preferably has as high a work function as possible. For example, elemental metals such as gold, platinum, silver, copper, nickel, palladium, cobalt, selenium, vanadium, and tungsten, mixtures containing these metals, alloys of these metals, and metal oxides such as tin oxide, zinc oxide, indium oxide, indium tin oxide (ITO), and indium zinc oxide can be used. Conductive polymers such as polyaniline, polypyrrole, and polythiophene can also be used. These electrode materials may be used alone or in combination of two or more. The anode may be composed of a single layer or a plurality of layers. When the anode is used as a reflection electrode, for example, chromium, aluminum, silver, titanium, tungsten, molybdenum, an alloy thereof, or a laminate thereof can be used. When the anode is used as a transparent electrode, for example, a transparent conductive layer made of an oxide such as indium tin oxide (ITO) or indium zinc oxide can be used, but these materials are non-limiting examples. Photolithography can be used for anode formation.

The constituent material for the cathode preferably has a low work function. Examples of such materials include alkali metals such as lithium; alkaline earth metals such as calcium; elemental metals such as aluminum, titanium, manganese, silver, lead, and chromium; and mixtures containing these elemental metals. Alloys of these elemental metals can also be used. For example, magnesium-silver, aluminum-lithium, aluminum-magnesium, silver-copper, and zinc-silver can be used. Metal oxides such as indium tin oxide (ITO) can also be used. These electrode materials may be used alone or in combination of two or more. The cathode may be composed of a single layer or a plurality of layers. In particular, silver is preferably used, and a silver alloy is more preferred to suppress aggregation of silver. As long as aggregation of silver can be suppressed, the content ratio in the alloy is not limited, and may be, for example, 1:1.

The cathode is not particularly limited, and may be formed as a conductive oxide layer of ITO or the like to provide a top-emission element or may be formed as a reflection electrode of aluminum (Al) or the like to provide a bottom-emission element. The cathode may be formed by any method. For example, DC and AC sputtering methods are preferably used because these methods provide good film coverage and readily reduce resistance.

After the cathode is formed, a protective layer may be disposed. For example, by bonding a glass plate provided with a moisture absorbent to the cathode, permeation of water and the like into the organic compound layer can be suppressed, and the occurrence of a display failure can be suppressed. In another embodiment, a passivation film made of silicon nitride or the like may be disposed on the cathode to suppress permeation of water and the like into the organic compound layer. For example, the protective layer may be formed in such a manner that after the formation of the cathode, the resultant is conveyed to another chamber without breaking the vacuum, and a silicon nitride film having a thickness of 2 um is formed by CVD. After the film formation by CVD, atomic layer deposition (ALD) may be performed to form a protective layer.

Color filters may be disposed on pixels. For example, color filters sized to fit pixels may be disposed on another substrate and bonded to a substrate disposed on the organic light-emitting element. Alternatively, color filters may be patterned by photolithography on a protective layer made of silicon oxide or the like.

The organic compound layers (e.g., the hole injection layer, the hole transport layer, the electron blocking layer, the light-emitting layer, the hole blocking layer, the electron transport layer, and the electron injection layer) constituting the organic light-emitting element according to this embodiment are formed by any of the following methods. Specifically, a dry process such as vacuum deposition, ion plating, sputtering, or plasma deposition can be used to form the organic compound layers. Instead of the dry process, a wet process in which a solution in an appropriate solvent is applied by a known coating method (e.g., spin coating, dipping, casting, the LB technique, or an ink jet method) to form a layer can also be used. When the layers are formed by, for example, vacuum deposition or solution coating, the layers are unlikely to undergo crystallization or the like and are highly stable over time. When a coating method is used for film formation, an appropriate binder resin can be used in combination to form a film. Examples of the binder resin include, but are not limited to, polyvinylcarbazole resins, polycarbonate resins, polyester resins, ABS resins, acrylic resins, polyimide resins, phenol resins, epoxy resins, silicone resins, and urea resins. The binder resins may be used alone as a homopolymer or copolymer or may be used as a mixture of two or more. In addition, known additives such as plasticizers, antioxidants, and UV absorbers may optionally be used in combination.

### <Device and Apparatus Including Organic Light-Emitting Element>

The organic light-emitting element according to this embodiment can be used as a constituent member of a display device or an illumination apparatus. Other applications include an exposure light source in an electrophotographic image-forming apparatus, a backlight in a liquid crystal display, and a light-emitting apparatus including a white light source with a color filter.

The display device may be an image information processor that includes an image input unit to which image information from an area CCD, a linear CCD, a memory card, or the like is input, includes an information-processing unit that processes the input information, and displays the input image on a display unit. The display unit of an image pickup device or an ink-jet printer may have a touch panel function. The touch panel function may be activated by any system, such as an infrared system, an electrostatic capacitive system, a resistive film system, or an electromagnetic induction system. The display device may also be used in a display unit of a multifunctional printer.

The use of a device including the organic light-emitting element according to this embodiment enables a stable display with good image quality over a long period of time.

### <Display Device>

A display device according to this embodiment includes a plurality of pixels, and at least one of the pixels includes the organic light-emitting element according to this embodiment. The pixels include the organic light-emitting element according to this embodiment and an active element. The display device may be used as a display unit of an image display apparatus including an input unit for inputting image information and the display unit for outputting an image.

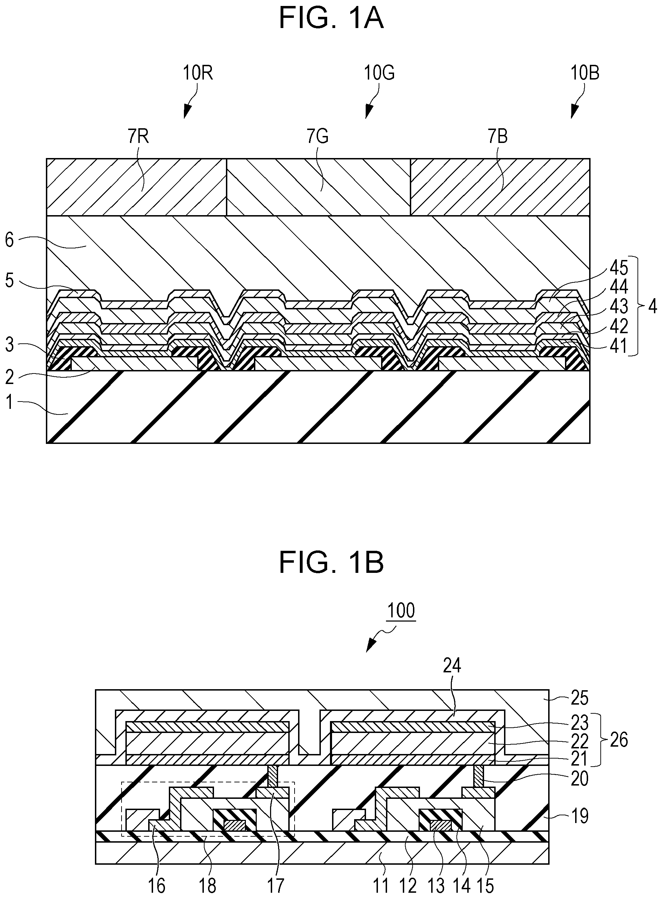

Fig. 1 shows schematic sectional views of examples of the display device according to this embodiment.

Fig. 1A is a schematic sectional view of an example of a pixel constituting the display device according to this embodiment. The pixel includes subpixels 10. The subpixels are divided into 10R, 10G, and 10B according to their light emission. The emission color may be distinguished on the basis of the wavelength of light emitted from a light-emitting layer, or light emitted from the subpixels may undergo selective transmission or color conversion through a color filter or the like. Each subpixel includes, on an interlayer insulating layer 1, a reflective electrode 2 serving as a first electrode, an insulating layer 3 that covers the edge of the reflective electrode 2, an organic compound layer 4 that covers the first electrode and the insulating layer, a transparent electrode 5, a protective layer 6, and a color filter 7.

The interlayer insulating layer 1 may include a transistor and a capacitor element below or inside the interlayer insulating layer 1. The transistor and the first electrode may be electrically connected to each other through a contact hole (not illustrated) or the like.

The insulating layer 3 is also referred to as a bank or a pixel-separating film. The insulating layer 3 is disposed so as to cover the edge of the first electrode and surround the first electrode. A portion in which the insulating layer is not disposed is in contact with the organic compound layer 4 and serves as a light-emitting region.

The organic compound layer 4 includes a hole injection layer 41, a hole transport layer 42, a first light-emitting layer 43, a second light-emitting layer 44, and an electron transport layer 45.

The second electrode 5 may be a transparent electrode, a reflective electrode, or a semitransparent electrode.

The protective layer 6 reduces permeation of water into the organic compound layer. Although the protective layer is illustrated as a single layer, it may be constituted by a plurality of layers. The layers may be constituted by an inorganic compound layer and an organic compound layer.

The color filter 7 is divided into 7R, 7G, and 7B according to their color. The color filter may be formed on a planarizing film (not illustrated). A resin protective layer (not illustrated) may be disposed on the color filter. The color filter may be formed on the protective layer 6. The color filter may be bonded after being formed on a counter substrate such as a glass substrate.

Fig. 1B is a schematic sectional view illustrating an example of a display device including an organic light-emitting element and a transistor connected to the organic light-emitting element. An organic light-emitting element 26 includes an anode 21, an organic compound layer 22, and a cathode 23. The transistor is an example of an active element. The transistor may be a thin film transistor (TFT) .

A display device 100 in Fig. 1B includes a substrate 11 made of, for example, glass or silicon and an insulating layer 12 disposed on the substrate. An active element 18 such as a TFT is disposed on the insulating layer, and a gate electrode 13, a gate insulating film 14, and a semiconductor layer 15 of the active element are disposed. The TFT 18 also includes the semiconductor layer 15, a drain electrode 16, and a source electrode 17. An insulating film 19 is disposed over the TFT 18. The anode 21 constituting the organic light-emitting element and the source electrode 17 are connected to each other through a contact hole 20 extending through the insulating film.

The electrodes (anode and cathode) included in the organic light-emitting element 26 and the electrodes (source electrode and drain electrode) included in the TFT need not necessarily be electrically connected to each other in the manner illustrated in Fig. 1B. It is only required that either the anode or the cathode be electrically connected to either the source electrode or the drain electrode of the TFT. TFT refers to a thin-film transistor.

Although the organic compound layer is illustrated as a single layer in the display device 100 in Fig. 1B, the organic compound layer 22 may be composed of multiple layers. A first protective layer 24 and a second protective layer 25 for reducing deterioration of the organic light-emitting element are disposed over the cathode 23.

Although a transistor is used as a switching element in the display device 100 in Fig. 1B, another switching element may be used instead.

The transistor used in the display device 100 in Fig. 1B may not only be a transistor obtained using a single-crystal silicon wafer but also a thin-film transistor including a substrate and an active layer on an insulating surface of the substrate. The active layer may be made of, for example, single-crystal silicon, non-single-crystal silicon such as amorphous silicon or microcrystalline silicon, or a non-single-crystal oxide semiconductor such as indium zinc oxide or indium gallium zinc oxide. The thin-film transistor is also referred to as a TFT element.

The transistor included in the display device 100 in Fig. 1B may be formed in a substrate such as a Si substrate. The phrase "formed in a substrate" means producing a transistor by processing a substrate itself, such as a Si substrate. That is, having a transistor in a substrate can also mean that the substrate and the transistor are integrally formed.

The organic light-emitting element according to this embodiment has an emission luminance that is controlled by a TFT, which is an example of a switching element. Disposing a plurality of organic light-emitting elements in a screen enables a display of an image with different emission luminances. The switching element according to this embodiment need not necessarily be a TFT and may be a transistor formed of low-temperature polysilicon or an active matrix driver formed on a substrate such as a Si substrate. The active matrix driver may also be formed in the substrate. Whether a transistor is provided in the substrate or a TFT is used is chosen depending on the size of the display unit. For example, when the display unit has a size of about 0.5 inches, the organic light-emitting element is preferably disposed on a Si substrate.

The display device may include a plurality of light-emitting elements. The light-emitting elements may include a drive circuit. The drive circuit may be an active matrix-type circuit which independently controls the light emission of a first light-emitting element and a second light-emitting element. The active matrix-type circuit may be voltage programmed or current programmed. The drive circuit includes a pixel circuit for each pixel. The pixel circuit may include a light-emitting element, a transistor that controls the emission luminance of the light-emitting element, a transistor that controls the timing of light emission, a capacitor that holds the gate voltage of the transistor that controls the emission luminance, and a transistor for providing a connection to GND not through the light-emitting element.

The interval between the light-emitting elements constituting a light-emitting apparatus may be 10 um, 7 um, or 5 um or less.

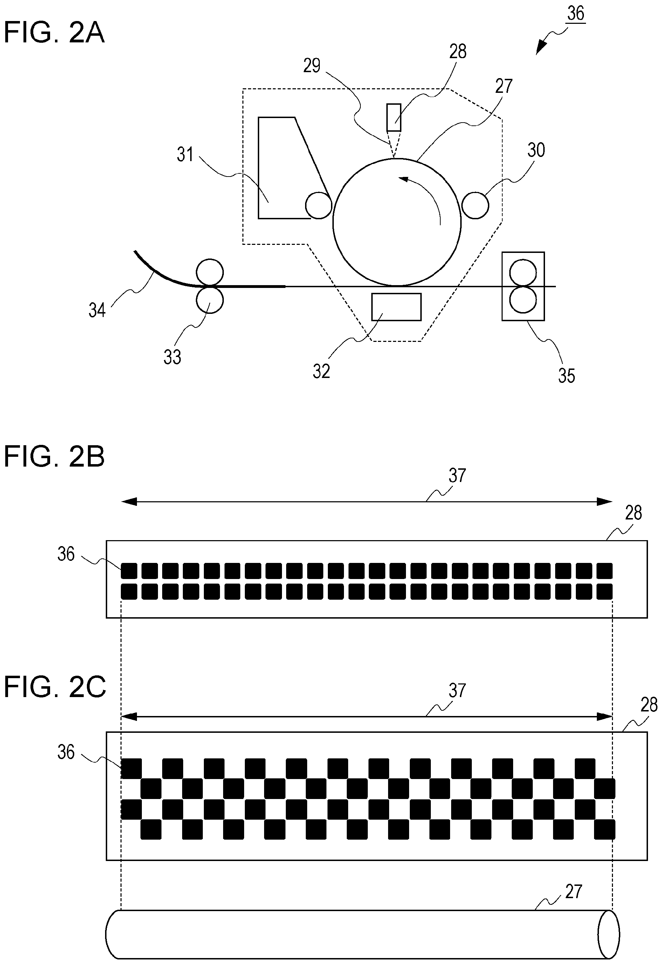

Fig. 2(a) is a schematic view of an image forming apparatus 36 according to an embodiment of the present invention. The image forming apparatus includes a photoreceptor, an exposure light source, a developing unit, a charging unit, a transfer unit, a conveying roller, and a fixing unit.

An exposure light source 28 emits light 29 to form an electrostatic latent image on the surface of a photoreceptor 27. The exposure light source includes an organic light-emitting element according to the present invention. A developing unit 31 contains toner and the like. A charging unit 30 charges the photoreceptor. A transfer unit 32 transfers a developed image onto a recording medium 34. A conveying unit 33 conveys the recording medium 34. The recording medium 34 is paper, for example. A fixing unit 35 fixes an image formed on the recording medium.

Fig. 2(b) and Fig. 2(c) schematically illustrate how a plurality of light-emitting portions 38 are arranged on a long substrate in the exposure light source 28. Reference numeral 37 indicates a row direction which is a direction parallel to the axis of the photoreceptor and in which organic light-emitting elements are aligned. The row direction is the same as the direction of the rotation axis of the photoreceptor 27. This direction can also be referred to as the major-axis direction of the photoreceptor.

In Fig. 2(b), the light-emitting portions are arranged along the major-axis direction of the photoreceptor. In Fig. 2(c), unlike Fig. 2(b), the light-emitting portions are alternately arranged in the row direction in a first row and a second row. The first row and the second row are located at different positions in the column direction.

In the first row, the plurality of light-emitting portions are arranged at intervals. In the second row, the light-emitting portions are arranged at positions corresponding to the spaces between the light-emitting portions in the first row. That is, the plurality of light-emitting portions are arranged at intervals also in the column direction.

The arrangement in Fig. 2(c) can also be referred to as, for example, a lattice arrangement, a staggered arrangement, or a checkered pattern.

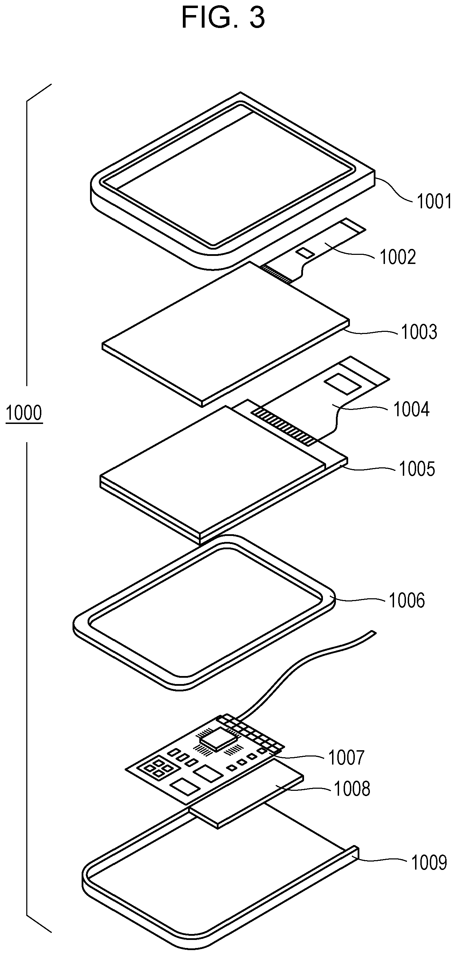

Fig. 3 is a schematic view showing an example of a display device according to an exemplary embodiment. A display device 1000 may include an upper cover 1001, a lower cover 1009, and a touch panel 1003, a display panel 1005, a frame 1006, a circuit board 1007, and a battery 1008 disposed between the upper cover 1001 and the lower cover 1009. Flexible print circuits (FPCs) 1002 and 1004 are connected to the touch panel 1003 and the display panel 1005, respectively. The organic light-emitting element according to this embodiment may be used in the display panel 1005. A transistor is printed on the circuit board 1007. The battery 1008 may be omitted if the display device is not a mobile device. If the display device is a mobile device, the battery 1008 need not necessarily be disposed at this position.

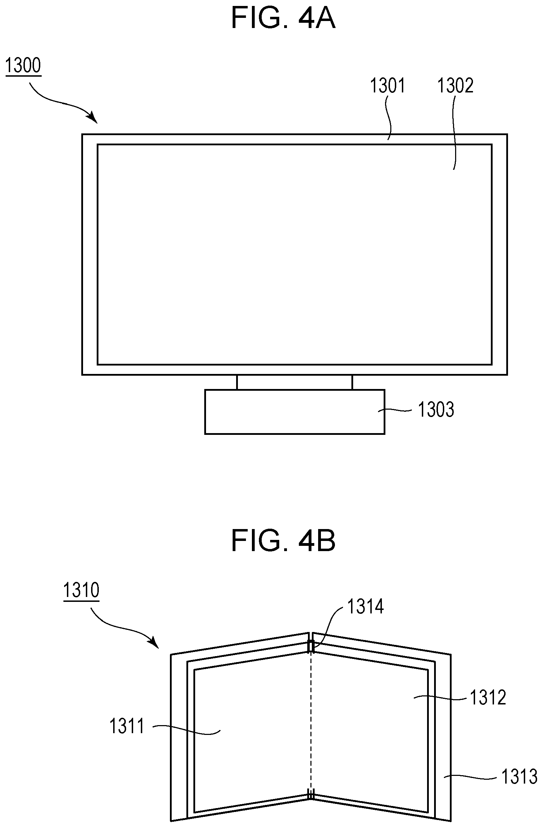

Fig. 4 shows schematic views of examples of the display device according to this embodiment. Fig. 4A is a display device such as a television monitor or a PC monitor. A display device 1300 includes a frame 1301 and a display unit 1302. The organic light-emitting element according to this embodiment may be used in the display unit 1302. The display device 1300 includes a base 1303 that supports the frame 1301 and the display unit 1302. The base 1303 need not necessarily be in the form illustrated in Fig. 4A. The lower side of the frame 1301 may serve as a base. The frame 1301 and the display unit 1302 may be curved. The radius of curvature may be 5000 mm or more and 6000 mm or less. A display device 1310 in Fig. 4B is configured to be folded and what is called a foldable display device. The display device 1310 includes a first display unit 1311, a second display unit 1312, a housing 1313, and a bending point 1314. The first display unit 1311 and the second display unit 1312 may include the organic light-emitting element according to this embodiment. The first display unit 1311 and the second display unit 1312 may be a seamless, monolithic display device. The first display unit 1311 and the second display unit 1312 can be divided by the bending point. The first display unit 1311 and the second display unit 1312 may display different images, or the first and second display units may together display a single image.

### <Photoelectric Conversion Apparatus>

The display device according to this embodiment may be used as a display unit of a photoelectric conversion apparatus, such as an image pickup device, that includes an optical unit including a plurality of lenses and an image pickup element that receives light that has passed through the optical unit. The photoelectric conversion apparatus may include a display unit that displays information acquired by the image pickup element. The display unit may be exposed to the outside of the photoelectric conversion apparatus or disposed in a viewfinder. The photoelectric conversion apparatus may be a digital camera or a digital camcorder.

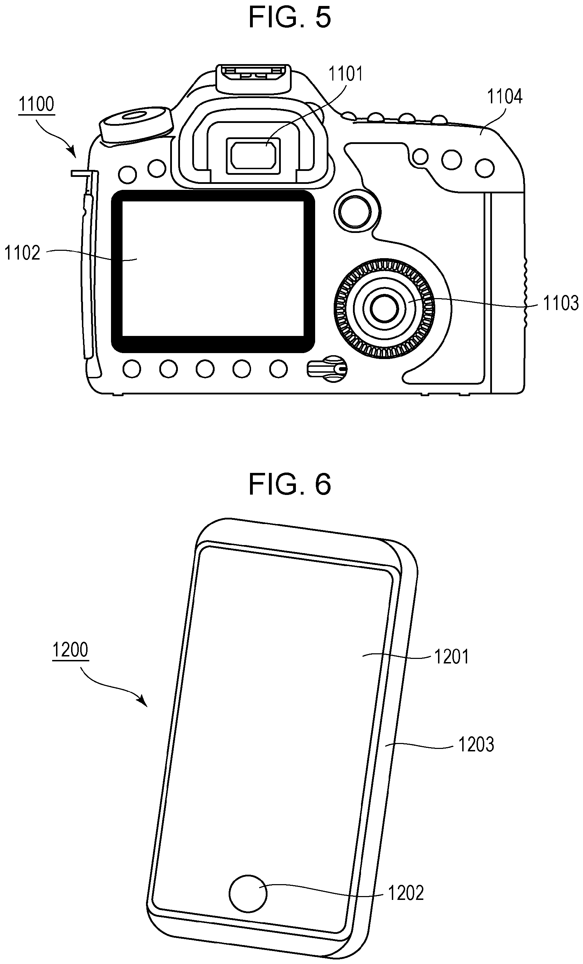

Fig. 5 is a schematic view showing an example of an image pickup device according to this embodiment. An image pickup device 1100 may include a viewfinder 1101, a rear display 1102, an operation unit 1103, and a housing 1104. The viewfinder 1101 may include the display device according to this embodiment. In this case, the display device may display not only an image to be captured but also environmental information, image capture instructions, and the like. The environmental information may be, for example, the intensity of external light, the direction of external light, the moving speed of a subject, and the possibility that the subject is hidden by an object. Since the timing appropriate for capturing an image is only a moment, the information is desirably displayed as quickly as possible. Thus, the display device including the organic light-emitting element of the present invention is preferably used. This is because the organic light-emitting element has a high response speed. The display device including the organic light-emitting element is more suitable for use in a device that requires speedy display than a liquid crystal display. The image pickup device 1100 includes an optical unit (not illustrated). The optical unit includes a plurality of lenses and focuses an image on the image pickup element accommodated in the housing 1104. By adjusting the relative positions of the plurality of lenses, the focal point can be adjusted. This operation can also be performed automatically.

### <Electronic Device>

The display device according to this embodiment may be used in a display unit of an electronic device such as a mobile terminal. In this case, the display device may have both a display function and an operating function. Examples of the mobile terminal include cellular phones such as smart phones, tablets, and head mount displays.

Fig. 6 is a schematic view showing an example of a mobile device according to this embodiment. A mobile device 1200 includes a display unit 1201, an operation unit 1202, and a housing 1203. The housing 1203 may include a circuit, a printed board including the circuit, a battery, and a communication unit. The operation unit 1202 may be a button or a touch-sensitive response unit. The operation unit may be a biometric recognition unit that, for example, releases a lock upon recognition of fingerprints. A mobile device including a communication unit can also be referred to as a communication device.

### <Illumination Apparatus>

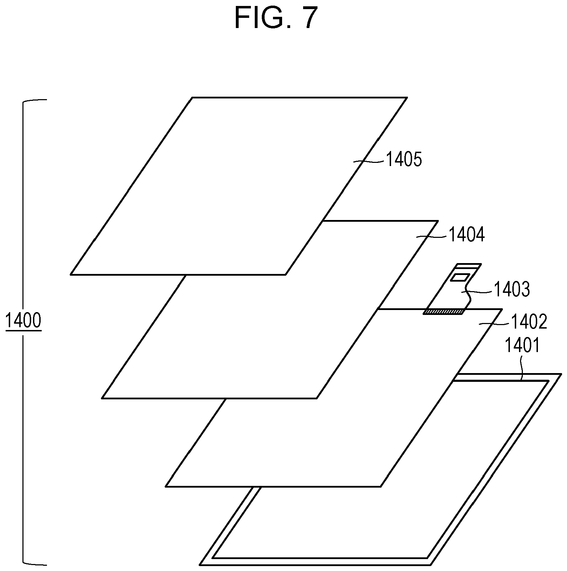

Fig. 7 is a schematic view showing an example of an illumination apparatus according to this embodiment. An illumination apparatus 1400 may include a housing 1401, a light source 1402, a circuit board 1403, an optical filter 1404, and a light diffusion unit 1405. The light source 1402 may include the organic light-emitting element according to this embodiment. The optical filter 1404 may be a filter for improving the color rendering properties of the light source 1402. The light diffusion unit 1405 effectively diffuses light from the light source 1402 and enables the light to reach a wide region for, for example, lighting up. If necessary, a cover may be disposed at an outermost portion.

The illumination apparatus is, for example, an indoor illumination apparatus. The illumination apparatus may emit light of cool white, day white, or any other color from blue to red. The illumination apparatus may include a modulation circuit that modulates the light. The illumination apparatus may include the organic light-emitting element of the present invention and a power supply circuit connected thereto. The power supply circuit is a circuit that converts AC voltage to DC voltage. The illumination apparatus may include an inverter circuit. Cool white has a color temperature of 4200 K, and day white has a color temperature of 5000 K. The illumination apparatus may include a color filter. The illumination apparatus according to this embodiment may also include a heat dissipation unit. The heat dissipation unit dissipates heat in the apparatus to the outside and is formed of, for example, a metal with high specific heat or liquid silicon.

### <Moving Object>

A moving object according to this embodiment may be, for example, an automobile, a ship, an aircraft, or a drone. The moving object may include a body and a lighting fixture disposed on the body. The lighting fixture may emit light for allowing the position of the body to be recognized. The lighting fixture includes the organic light-emitting element according to this embodiment.

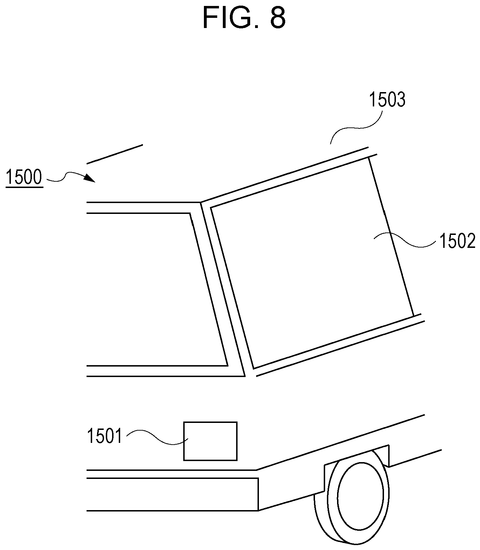

Fig. 8 is a schematic view showing an example of the moving object according to this embodiment and illustrates an automobile including a tail lamp, which is an example of a vehicle lighting fixture. An automobile 1500 serving as a body includes a tail lamp 1501, and the tail lamp 1501 may be configured to be turned on in response to, for example, brake operation. The tail lamp 1501 may include the organic light-emitting element according to this embodiment. The tail lamp 1501 may include a protective member that protects the organic light-emitting element. The protective member may be made of any material that has a certain degree of high strength and is transparent, but is preferably made of a polycarbonate or the like. The polycarbonate may be mixed with a furandicarboxylic acid derivative, an acrylonitrile derivative, or the like. The automobile 1500 may include a car body 1503 and a window 1502 attached thereto. The window 1502 may be a transparent display unless it is a window for checking the front and rear of the automobile 1500. The transparent display may include the organic light-emitting element according to this embodiment. In this case, components of the organic light-emitting element, such as electrodes, are formed of transparent materials.

### <Smart Glasses>

Application examples of the display devices according to the above-described embodiments will be described with reference to Fig. 7. The display devices can be applied to systems that can be worn as wearable devices such as smart glasses, HMDs, and smart contact lenses. An image pickup and display device used in such an application example includes an image pickup device that can photoelectrically convert visible light and a display device that can emit visible light.

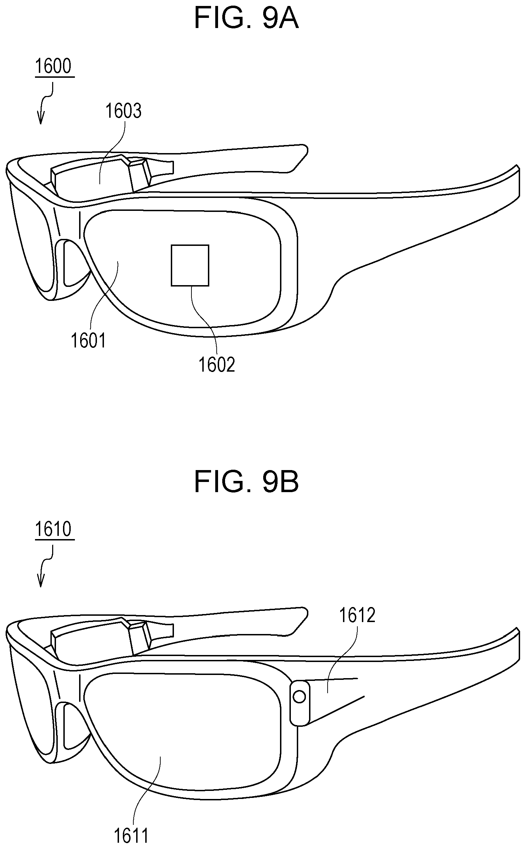

Fig. 9A illustrates eyeglasses 1600 (smart glasses) according to one application example. An image pickup device 1602, such as a CMOS sensor or a SPAD, is disposed on the front side of a lens 1601 of the eyeglasses 1600. The display device according to any one of the above-described embodiments is provided on the rear side of the lens 1601.

The eyeglasses 1600 further include a controller 1603. The controller 1603 functions as a power source for supplying electricity to the image pickup device 1602 and the display device according to any of the embodiments. The controller 1603 controls the operation of the image pickup device 1602 and the display device. The lens 1601 is provided with an optical system for focusing light on the image pickup device 1602.

Fig. 9B illustrates eyeglasses 1610 (smart glasses) according to one application example. The eyeglasses 1610 include a controller 1612, and the controller 1612 is equipped with an image pickup device corresponding to the image pickup device 1602 and a display device. A lens 1611 is provided with the image pickup device in the controller 1612 and an optical system for projecting light emitted from the display device, and an image is projected onto the lens 1611. The controller 1612 functions as a power source for supplying electricity to the image pickup device and the display device and also controls the operation of the image pickup device and the display device. The controller may include a gaze detection unit that detects the gaze of a wearer. The gaze may be detected using infrared radiation. An infrared light emission unit emits infrared light to an eyeball of a user gazing at a displayed image. The reflection of the emitted infrared light from the eyeball is detected by an image pickup unit including a light-receiving element, whereby a captured image of the eyeball is obtained. Due to the presence of a reduction unit that reduces light from the infrared light emission unit to the display unit in plan view, degradation of image quality is reduced.

The gaze of the user toward the displayed image is detected from the captured image of the eyeball obtained by infrared imaging. Any known method can be used for the gaze detection using the captured image of the eyeball. For example, a gaze detection method based on a Purkinje image formed by the reflection of irradiation light on a cornea can be used.

More specifically, a gaze detection process based on a pupil-corneal reflection method is performed. Using the pupil-corneal reflection method, a gaze vector representing the direction (rotation angle) of the eyeball is calculated on the basis of a pupil image and a Purkinje image included in the captured image of the eyeball, whereby the gaze of the user is detected.

A display device according to an embodiment of the present invention may include an image pickup device including a light-receiving element and may control a displayed image on the display device on the basis of the gaze information of the user from the image pickup device.

Specifically, the display device determines, on the basis of the gaze information, a first visual field at which the user gazes and a second visual field other than the first visual field. The first visual field and the second visual field may be determined by the controller of the display device, or may be determined by an external controller and sent therefrom. In a display area of the display device, the display resolution of the first visual field may be controlled to be higher than the display resolution in the second visual field. That is, the resolution in the second visual field may be set to be lower than that in the first visual field.

The display area includes a first display area and a second display area different from the first display area, and an area of high priority is determined from the first display area and the second display area on the basis of the gaze information. The first visual field and the second visual field may be determined by the controller of the display device, or may be determined by an external controller and sent therefrom. The resolution in the area of high priority may be controlled to be higher than the resolution in the area other than the area of high priority. That is, the resolution in an area of relatively low priority may be set to be lower.

AI may be used to determine the first visual field or the area of high priority. AI may be a model configured to estimate, from an image of an eyeball, the angle of gaze and the distance to an object gazed, by using the image of the eyeball and the actual direction of gaze of the eyeball in the image as teaching data. The AI program may be included in the display device, the image pickup device, or an external device. When the AI program is included in the external device, it is transmitted to the display device via communications.

When display control is performed on the basis of visual recognition, smart glasses further including an image pickup device that captures an external image are suitable for use. Smart glasses can display captured external information in real time.

### EXAMPLES

The present invention will now be described with reference to Examples. It should be noted that these Examples are not intended to limit the present invention.

### [Example 1 (synthesis of exemplary compound A2)]

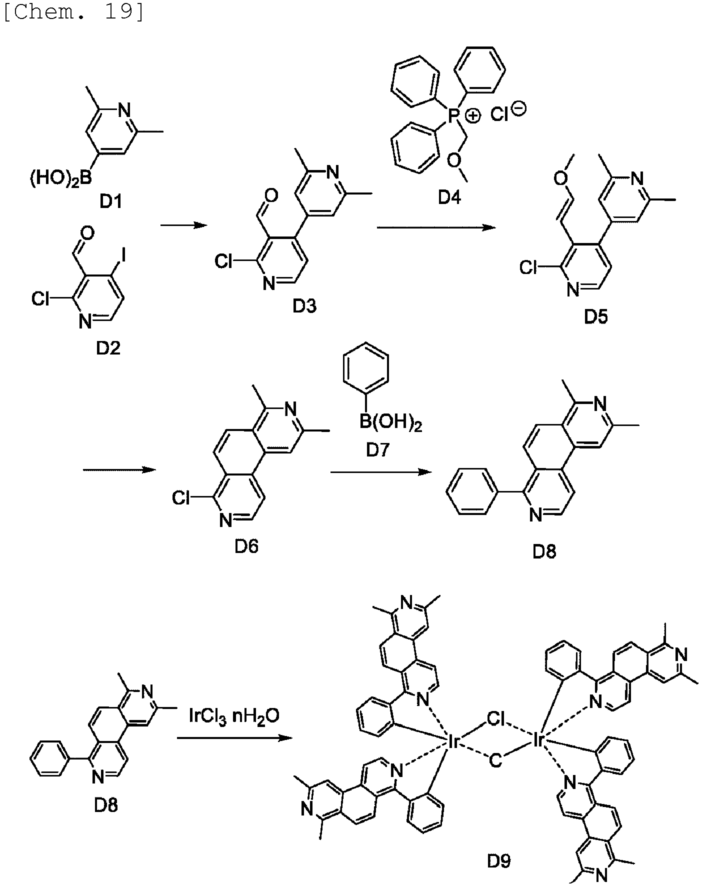

After a 2-ethoxyethanol (4 ml) solvent was degassed, 0.16 g (0.45 mmol) of iridium (III) chloride hydrate was added, and the resultant was stirred at room temperature for 30 minutes. Thereafter, 0.26 g (0.94 mmol) of D8 was added, and the resultant was heated to 120° and stirred for 6 hours. After cooling, water was added, and the resultant was filtered and washed with water. The resultant was dried to obtain 0.27 g of a red individual D9 (yield: 90%).

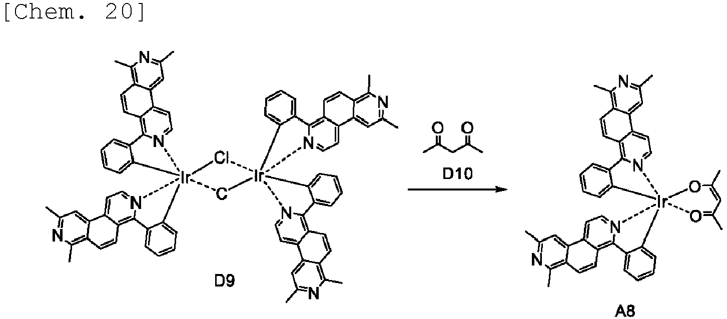

After a 2-ethoxyethanol (5 ml) solvent was degassed, 0.20 g (0.13 mmol) of D9 and 52 mg (0.52 mmol) of acetylacetone were added, and the resultant was stirred at room temperature for 30 minutes. Thereafter, 0.14 g (1.3 mmol) of sodium carbonate was added, and the resultant was heated to 100° and stirred for 6 hours. After cooling, methanol was added, and the resultant was filtered and washed with methanol. The resultant was dried to obtain 0.16 g of a dark red individual A8 (yield: 72%).

The emission spectrum of a toluene solution of exemplary compound A8 at 1 × 10⁻⁵ mol/L was measured by photoluminescence spectroscopy at an excitation wavelength of 350 nm by using an F-4500 manufactured by Hitachi, Ltd. The spectrum showed a maximum intensity at 615 nm.

Exemplary compound A2 was subjected to mass spectrometry using MALDI-TOF-MS (Autoflex LRF manufactured by Bruker Corporation).

### [MALDI-TOF-MS]

### Measured value: m/z = 858, Calculated value: C₅₂H₂₆ = 858

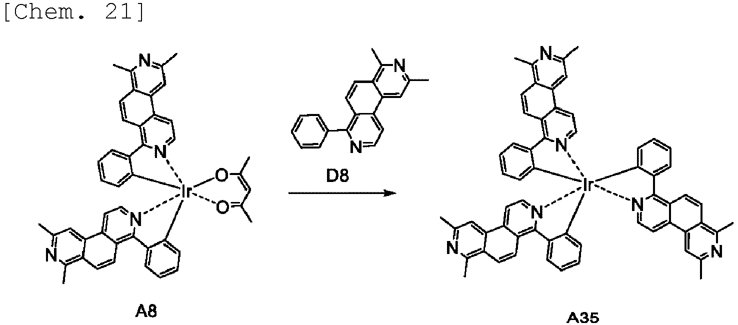

A8 in an amount of 100 mg (0.117 mmol) and D8 in an amount of 333 mg (1.17 mmol) were heated to 230°C and stirred for 3 hours. After cooling to 100°C, 2 mL of toluene was added, and the resultant was stirred to room temperature. Subsequently, heptane was added, and the resultant was filtered. The residue was purified by silica gel column chromatography (mobile phase; ethyl acetate) to obtain 13.0 mg of a dark red solid A35 (yield: 11%).

The emission spectrum of a toluene solution of exemplary compound A35 at 1 × 10⁻⁵ mol/L was measured by photoluminescence spectroscopy at an excitation wavelength of 350 nm by using an F-4500 manufactured by Hitachi, Ltd. The spectrum showed a maximum intensity at 610 nm.

Exemplary compound A35 was subjected to mass spectrometry using MALDI-TOF-MS (Autoflex LRF manufactured by Bruker Corporation).

### [MALDI-TOF-MS]

### Measured value: m/z = 1042, Calculated value: C₅₂H₂₆ = 1042

### [Examples 2 to 20 (synthesis of exemplary compounds)]

Exemplary compounds of Examples 2 to 20 shown in Table 3 were synthesized in the same manner as in Example 1 except that raw materials D1, D7, and D10 in Example 1 were replaced with raw material 1, raw material 2, and raw material 3, respectively. Measured values (m/z) of mass spectrometry determined in the same manner as in Example 1 are also shown.

### [Table 3-1]

**Table 3-1**

| Example | Exemplary compound | Raw material 1 | Raw material 2 | Raw material 3 | m/z |
|---|---|---|---|---|---|
| 2 | 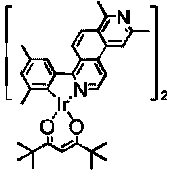 | 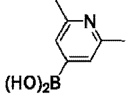 | 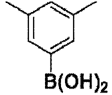 | 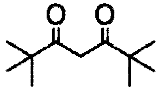 | 998 |
| 3 | 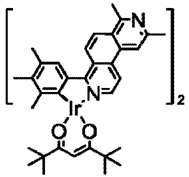 | 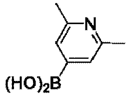 | 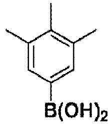 | 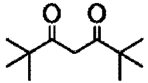 | 1026 |
| 4 | 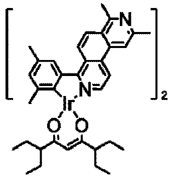 | 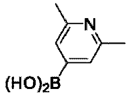 | 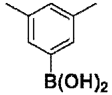 | 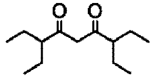 | 1026 |
| 5 | 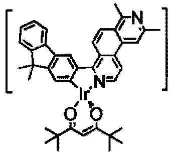 | 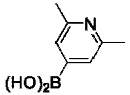 | 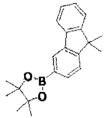 | 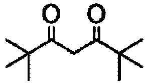 | 1175 |
| 6 | 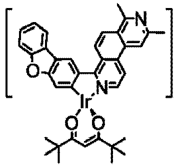 | 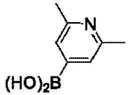 | 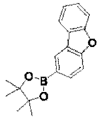 | 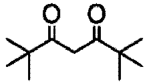 | 1122 |

### [Table 3-2]

**Table 3-2**

| Example | Exemplary compound | Raw material 1 | Raw material 2 | Raw material 3 | m/z |
|---|---|---|---|---|---|
| 7 | 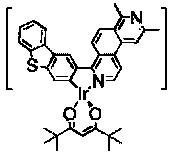 | 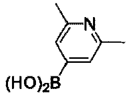 | 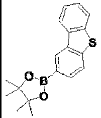 | 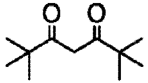 | 1154 |
| 8 | 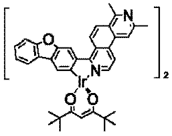 | 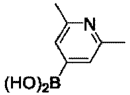 | 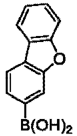 | 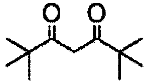 | 1122 |
| 9 | 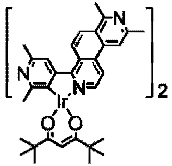 | 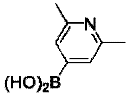 | 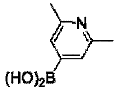 | 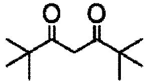 | 1000 |
| 10 | 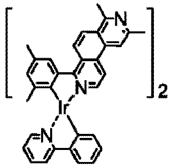 | 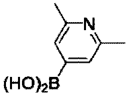 | 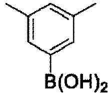 | 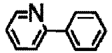 | 969 |
| 11 | 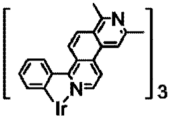 | 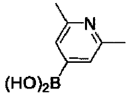 | 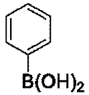 | 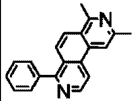 | 1042 |
| 12 | 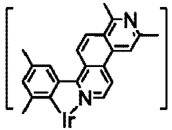 | 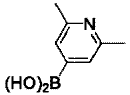 | 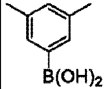 | 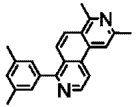 | 1126 |

### [Table 3-3]

**Table 3-3**

| Example | Exemplary compound | Raw material 1 | Raw material 2 | Raw material 3 | m/z |
|---|---|---|---|---|---|
| 13 | 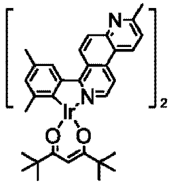 | 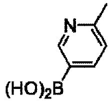 | 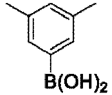 | 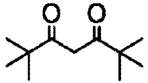 | 970 |
| 14 | 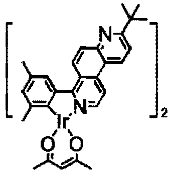 | 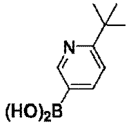 | 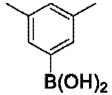 | 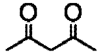 | 970 |
| 15 | 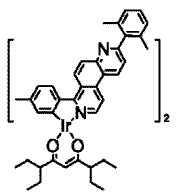 | 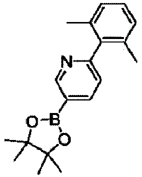 | 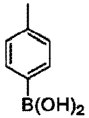 | 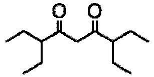 | 1151 |
| 16 | 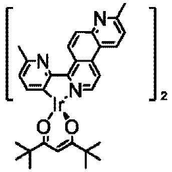 | 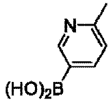 | 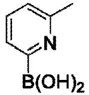 | 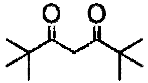 | 944 |
| 17 | 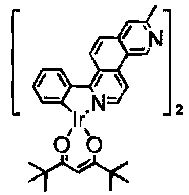 | 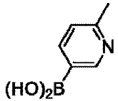 | 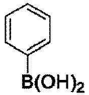 | 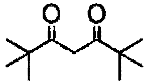 | 914 |

### [Table 3-4]

**Table 3-4**

| Example | Exemplary compound | Raw material 1 | Raw material 2 | Raw material 3 | m/z |
|---|---|---|---|---|---|
| 18 | 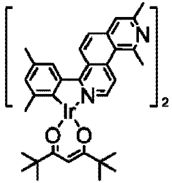 | 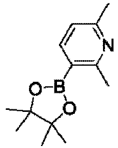 | 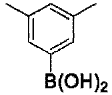 | 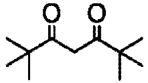 | 998 |
| 19 | 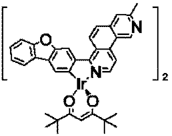 | 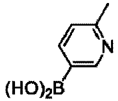 | 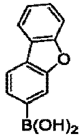 | 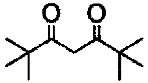 | 1094 |
| 20 | 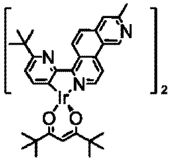 | 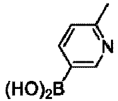 | 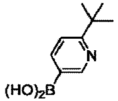 | 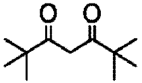 | 1028 |

### [Example 21]

An organic light-emitting element having a bottom-emission structure was produced in which an anode, a hole injection layer, a hole transport layer, an electron blocking layer, a light-emitting layer, a hole blocking layer, an electron transport layer, an electron injection layer, and a cathode were sequentially formed on a substrate.

First, an ITO film was formed on a glass substrate and subjected to desired patterning to form an ITO electrode (anode). At this time, the ITO electrode was formed so as to have a thickness of 100 nm. The substrate on which the ITO electrode was formed in this manner was used as an ITO substrate in the following process. Next, organic compound layers and an electrode layer shown in Table 4 were successively formed on the ITO substrate by performing vacuum deposition by resistance heating in a vacuum chamber at 1.33 × 10⁻⁴ Pa. At this time, the electrode area of the counter electrode (metal electrode layer, cathode) was set to 3 mm².

### [Table 4]

**Table 4**

| | Material | | | Thickness (nm) |
|---|---|---|---|---|
| Cathode | Al | | | 100 |
| Electron injection layer (EIL) | LiF | | | 1 |
| Electron injection layer (ETL) | ET2 | | | 20 |
| Hole blocking layer (HBL) | ET11 | | | 20 |
| Light-emitting layer (EML) | Host | EM16 | Mass ratio EM16:A8 = 96:4 | 20 |
| | Guest | A8 | | |
| Electron blocking layer (EBL) | HT19 | | | 15 |
| Hole transport layer (HTL) | HT3 | | | 30 |
| Hole injection layer (HIL) | HT16 | | | 5 |

The characteristics of the element obtained were measured and evaluated. The light-emitting element had a maximum emission wavelength of 617 nm and a maximum external quantum efficiency (E.Q.E.) of 22% and emitted red light with a chromaticity of (X, Y) = (0.69, 0.32). Furthermore, a continuous driving test at a current density of 100 mA/cm² was performed to measure the time taken for luminance degradation to reach 5%. When the time taken for luminance degradation to reach 5% in Comparative Example 1 was taken as 1.0, the luminance degradation ratio in this Example was 1.0.

In this Example, the following measurement apparatuses were used. Specifically, the current-voltage characteristics were measured with a microammeter 4140B manufactured by Hewlett-Packard Company, and the emission luminance was measured with a BM7 manufactured by TOPCON Corporation.

### [Examples 22 to 31 and Comparative Example 1]

In Examples 22 to 31, organic light-emitting elements were produced in the same manner as in Example 21 except that the compounds were appropriately changed to those shown in Table 5. The elements obtained were measured and evaluated for their characteristics in the same manner as in Example 21. The measurement results are shown in Table 6.

### [Table 5]

**Table 5**

| | HIL | HTL | EBL | EML | | HBL | ETL | E.Q.E [%] | Chromaticity coordinates (x, y) of red | Luminance degradation ratio |
|---|---|---|---|---|---|---|---|---|---|---|
| | | | | Host | Guest | | | | | |
| Example 22 | HT16 | HT3 | HT19 | EM9 | A9 | ET12 | ET15 | 23 | (0.70, 0.31) | 1.1 |
| Example 23 | HT16 | HT2 | HT15 | EM16 | A10 | ET12 | ET2 | 23 | (0.70, 0.31) | 1.0 |
| Example 24 | HT16 | HT2 | HT15 | EM16 | A11 | ET11 | ET2 | 23 | (0.70, 0.31) | 1.0 |
| Example 25 | HT16 | HT3 | HT19 | EM16 | A17 | ET12 | ET15 | 23 | (0.70, 0.31) | 1.0 |
| Example 26 | HT16 | HT3 | HT19 | EM16 | A20 | ET12 | ET15 | 23 | (0.70, 0.30) | 1.0 |
| Example 27 | HT16 | HT3 | HT19 | EM9 | A23 | ET11 | ET15 | 22 | (0.70, 0.31) | 1.0 |
| Example 28 | HT16 | HT3 | HT19 | EM16 | A26 | ET12 | ET2 | 22 | (0.70, 0.31) | 1.1 |
| Example 29 | HT16 | HT2 | HT15 | EM16 | A33 | ET12 | ET15 | 23 | (0.70, 0.31) | 1.2 |
| Example 30 | HT16 | HT3 | HT19 | EM9 | B5 | ET12 | ET15 | 21 | (0.69, 0.32) | 0.9 |
| Example 31 | HT16 | HT2 | HT15 | EM16 | C9 | ET11 | ET2 | 21 | (0.69, 0.32) | 0.9 |
| | | | | | | | | | | |
| Comparative Example 1 | HT16 | HT2 | HT15 | EM16 | Comparative compound 1-a | ET12 | ET2 | 20 | (0.65, 0.34) | 1.0 |
| Comparative Example 2 | HT16 | HT2 | HT15 | EM16 | Comparative compound 2-b | ET12 | ET2 | 15 | (0.68, 0.33) | 0.6 |

As shown above, the chromaticity coordinates in Comparative Example 1 were (0.65, 0.34), that is, the red light-emitting elements according to the present invention exhibited chromaticities closer to the color reproduction range of BT2020. This is because the organometallic complex according to the present invention emits red light at a longer wavelength.

The maximum external quantum efficiency (E.Q.E.) in Comparative Example 2 was 15%, that is, the red light-emitting elements according to the present invention had higher light emission efficiency. This is because the organometallic complex according to the present invention has a higher oscillator strength. Furthermore, the luminance degradation ratio in Comparative Example 2 was 0.6, that is, the red light-emitting elements according to the present invention had a longer life. This is because the organometallic complex according to the present invention has a nitrogen atom introduced at a position far from the metal atom and thus has high exciton stability.

The present invention is not limited to the above embodiments, and various alterations and modifications can be made without departing from the spirit and scope of the present invention. Accordingly, the following claims are attached to make public the scope of the present invention.

This application claims the benefit of Japanese Patent Application No. 2020-161442 filed September 25, 2020, which is hereby incorporated by reference in its entirety.

## Claims

1. An organometallic complex represented by general formula (1): 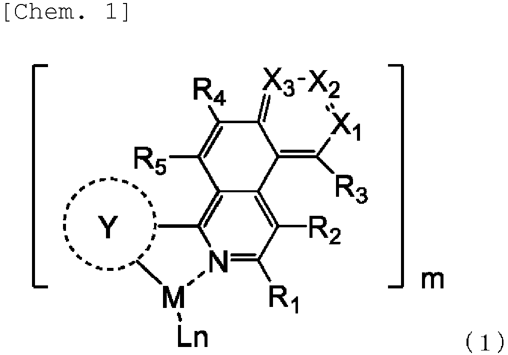
where, in formula (1), X₁ to X₃ are each independently selected from a carbon atom and a nitrogen atom, at least one of X₁ to X₃ is a nitrogen atom, the carbon atom has a hydrogen atom or a substituent, and the substituent is selected from a halogen atom, a substituted or unsubstituted alkyl group, a substituted or unsubstituted alkoxy group, a substituted or unsubstituted amino group, a substituted or unsubstituted aryl group, a substituted or unsubstituted heterocyclic group, a substituted or unsubstituted aryloxy group, a silyl group, and a cyano group,
Y is a substituted or unsubstituted aryl group or a substituted or unsubstituted heterocyclic group, and the aryl group or the heterocyclic group represented by Y may have a substituent selected from a halogen atom, a substituted or unsubstituted alkyl group, a substituted or unsubstituted alkoxy group, a substituted or unsubstituted amino group, a substituted or unsubstituted aryl group, a substituted or unsubstituted heterocyclic group, a substituted or unsubstituted aryloxy group, a silyl group, and a cyano group,
L is a bidentate ligand, M is a metal atom selected from Ir, Pt, Rh, Os, and Zn, m represents an integer of 1 to 3, and n represents an integer of 0 to 2, and
R₁ to R₅ are each independently selected from a hydrogen atom, a halogen atom, a substituted or unsubstituted alkyl group, a substituted or unsubstituted alkoxy group, a substituted or unsubstituted amino group, a substituted or unsubstituted aryl group, a substituted or unsubstituted heterocyclic group, a substituted or unsubstituted aryloxy group, a silyl group, and a cyano group.

2. The organometallic complex according to Claim 1, represented by general formula (2): 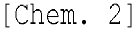 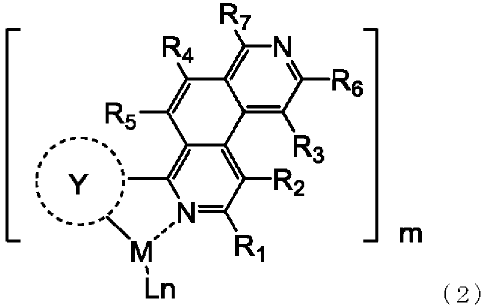 where R₁ to R₇ are each independently selected from a hydrogen atom, a halogen atom, a substituted or unsubstituted alkyl group, a substituted or unsubstituted alkoxy group, a substituted or unsubstituted amino group, a substituted or unsubstituted aryl group, a substituted or unsubstituted heterocyclic group, a substituted or unsubstituted aryloxy group, a silyl group, and a cyano group.

3. The organometallic complex according to Claim 1, represented by general formula (3): 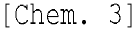 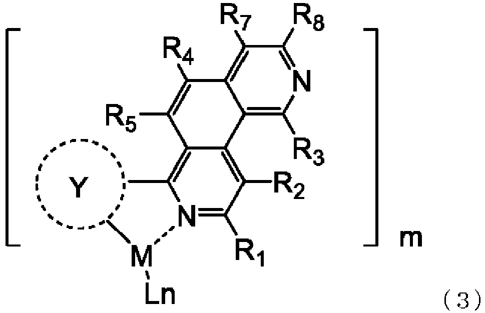 where R₁ to R₅, R₇, and R₈ are each independently selected from a hydrogen atom, a halogen atom, a substituted or unsubstituted alkyl group, a substituted or unsubstituted alkoxy group, a substituted or unsubstituted amino group, a substituted or unsubstituted aryl group, a substituted or unsubstituted heterocyclic group, a substituted or unsubstituted aryloxy group, a silyl group, and a cyano group.

4. The organometallic complex according to Claim 1, represented by general formula (4): 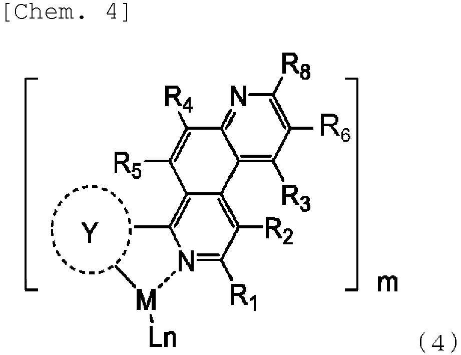 where R₁ to R₆ and R₈ are each independently selected from a hydrogen atom, a halogen atom, a substituted or unsubstituted alkyl group, a substituted or unsubstituted alkoxy group, a substituted or unsubstituted amino group, a substituted or unsubstituted aryl group, a substituted or unsubstituted heterocyclic group, a substituted or unsubstituted aryloxy group, a silyl group, and a cyano group.

5. The organometallic complex according to any one of Claims 1 to 4, wherein the organometallic complex includes three different ligands.

6. The organometallic complex according to Claim 5, wherein among lowest triplet excitation energies of the three different ligands, a lowest triplet excitation energy of a ligand shown in general formula (1) is lowest.

7. The organometallic complex according to any one of Claims 1 to 4, wherein m is 2, n is 1, and L is a structure represented by general formula (10) or (11): 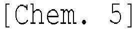 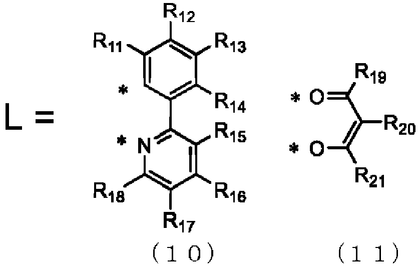 where, in general formulae (10) and (11), * represents a position of linkage or coordination with the metal.

8. The organometallic complex according to any one of Claims 1 to 7, wherein Y is a benzene ring having substituents at 3- and 5-positions thereof.

9. The organometallic complex according to any one of Claims 1 to 8, wherein M is iridium.

10. The organometallic complex according to Claim 1, having a substituent at an ortho position with respect to the nitrogen atom represented by X₁ to X₃.

11. The organometallic complex according to Claim 10, wherein the substituent is selected from a halogen atom and an alkyl group.

12. An organic light-emitting element comprising a first electrode, a second electrode, and an organic compound layer disposed between the first electrode and the second electrode, wherein the organic compound layer includes a layer containing the organometallic complex according to any one of Claims 1 to 11.

13. The organic light-emitting element according to Claim 12, wherein the layer containing the organometallic complex is a light-emitting layer.

14. The organic light-emitting element according to Claim 13, wherein the organic light-emitting element emits red light.

15. The organic light-emitting element according to Claim 13 or 14, further comprising another light-emitting layer stacked on the light-emitting layer, wherein the other light-emitting layer emits light having a color different from a color of light emitted from the light-emitting layer.

16. The organic light-emitting element according to Claim 13, wherein the organic light-emitting element emits white light.

17. A display device comprising a plurality of pixels, wherein the pixels include the organic light-emitting element according to any one of Claims 12 to 16 and an active element connected to the organic light-emitting element.

18. The display device according to Claim 17, comprising a color filter.

19. An image display apparatus, comprising an input unit for inputting image information and a display unit for outputting an image,
wherein the display unit includes the display device according to Claim 17 or 18.

20. A photoelectric conversion apparatus comprising an optical unit including a plurality of lenses, an image pickup element that receives light that has passed through the optical unit, and a display unit,
wherein the display unit displays information captured by the image pickup element, and the display unit includes the display device according to Claim 17 or 18.

21. An electronic device comprising a housing, a communication unit that communicates with an external unit, and a display unit,
wherein the display unit comprises the organic light-emitting element according to Claim 15 or 16.

22. An illumination apparatus comprising a light source, and a light diffusion unit or an optical filter,
wherein the light source includes the organic light-emitting element according to any one of Claims 12 to 16.

23. A moving object comprising a body and a lighting fixture disposed on the body,
wherein the lighting fixture includes the organic light-emitting element according to any one of Claims 12 to 16.

24. An image forming apparatus comprising a photoreceptor and an exposure light source that emits light onto the photoreceptor,
wherein the exposure light source includes the organic light-emitting element according to any one of Claims 12 to 16.
